# EUROPEAN PATENT APPLICATION

(11) **EP 2 881 379 A1**
(43) Date of publication of application: **10.06.2015**
(21) Application number: 13824771.3
(22) Date of filing: 31.07.2013
(51) Int. Cl.: C04B 35/00, C23C 14/24

(54) **OXIDE SINTERED BODY AND TABLET OBTAINED BY PROCESSING SAME**

(30) Priority: 31.07.2012 JP 2012170148
(71) Applicant: Sumitomo Metal Mining Co., Ltd., Tokyo 105-8716 (JP)
(72) Inventor: NAKAYAMA, Tokuyuki, Ichikawa-shi Chiba 272-8588 (JP)
(74) Representative: Müller-Boré & Partner Patentanwälte PartG mbB
(86) International application number: PCT/JP2013/070728
(87) International publication number: WO 2014/021374

(57) **Abstract**

The present invention provides a tablet for ion plating which allows high speed formation of transparent conductive films suitable for solar cells and allows continuous film formation without causing cracks, breakage or splashing, and a sintered oxide used for producing the tablet and comprising indium oxide as a main component and a specific amount of tin as an additive element.

Provided is a sintered oxide comprising indium oxide as a main component and tin as an additive element, and having a tin content of 0.001 to 0.15 in terms of an atomic ratio of Sn/ (In+Sn), wherein the sintered oxide mainly comprises crystal grains (A) having a tin content that is less than an average tin content of the sintered oxide and crystal grains (B) having a tin content that is at or above the average tin content of the sintered oxide, the difference in the average tin content between the crystal grains (B) and the crystal grains (A) being 0.015 or more in terms of the atomic ratio of Sn/(In+Sn), and has a density of 3.4 to 5.5 g/cm³.

## Description

### TECHNICAL FIELD

The present invention relates to a sintered oxide and a tablet obtained by processing the same, and more specifically, to a tablet for ion plating which allows high speed formation of transparent conductive films suitable for solar cells and allows continuous film formation without causing cracks, breakage or splashing, and to a sintered oxide used for obtaining the tablet.

### BACKGROUND ART

Transparent conductive films have high conductivity and high transmittance in the visible light region, and thus have been used for electrodes for solar cells, liquid crystal display devices and other various light receiving devices. Transparent conductive films also have been used for heat reflective films for automobile windows and architectural purposes, antistatic films and various transparent heat generators for antifogging purposes used for freezer display shelves and the like.

Well known practical transparent conductive films include thin films of tin oxide (SnO₂), zinc oxide (ZnO) and indium oxide (In₂O₃). Thin films of tin oxide utilized include those containing antimony as a dopant (ATO) and those containing fluorine as a dopant (FTO) and thin films of zinc oxide utilized include those containing aluminum as a dopant (AZO) and those containing gallium as a dopant (GZO). However, the most widely used transparent conductive films in industrial fields are of indium oxide. Among these, thin films of indium oxide containing tin as a dopant are referred to as ITO (Indium-Tin-Oxide) films, which particularly allow easy production of films having low resistance, and thus are widely used.

Transparent conductive films having low resistance are applied suitably to wide applications such as surface elements of solar cells, liquid crystals, organic electroluminescence and inorganic electroluminescence and touch panels. Well known production methods of the above various transparent conductive films include sputtering, vacuum deposition and ion plating methods.

Conventionally sputtering has been the mainstream of transparent conductive film formation techniques. Sputtering is an effective manner for formation of films from materials having low vapor pressure or when precise control of film thickness is required, and has been widely used in industrial fields because the operation thereof is very simple. Sputtering employs sputtering targets as materials of thin films. Targets are solid materials containing constituent elements of desired thin films and are sintered substances or, in some cases, single crystals of metal, metal oxide, metal nitride, metal carbide and the like. This method generally utilizes a vacuum device which is once brought to a high vacuum status before introduction of rare gas (argon and the like), and in which argon plasma is generated by glow discharge between an anode which is a substrate and a cathode which is a target under gas pressure of about 10 Pa or less, argon positive ions in the plasma are allowed to collide with the cathode which is the target, and constituent particles of the target sputtered thereby are deposited on the substrate to form a film.

Sputtering methods are classified based on the generation methods of argon plasma; sputtering utilizing high-frequency plasma is referred to as high-frequency sputtering and the one utilizing direct current plasma is referred to as direct current sputtering. Generally direct current sputtering has higher film formation speed than high-frequency sputtering, requires power-supply facilities which are inexpensive and requires simple film formation operations, and thus is widely used in industrial fields.

However, in recent years ion plating has been attracting attention that allows formation of transparent conductive films having the same or better quality compared to direct current sputtering. Ion plating is a method in which a material called tablet (or pellet) of metal or metal oxide is heated and evaporated by means of resistive heating or electron beam heating under pressure of about 10⁻³ to 10⁻² Pa and the evaporated product is activated together with reactant gas (oxygen) by plasma and then deposited on a substrate. Particularly ion plating using a pressure gradient plasma gun utilizes direct current arc discharge of high current and thus can generate plasma having high density and is characterized in that the evaporation speed of samples is higher than conventional direct current sputtering. Ion plating conventionally had a problem in that uniform film formation on large-area substrates is difficult due to uneven distribution of film quality or film thickness. However, the problem has been overcome by the technique of Patent Literature 1 for example in which the magnetic field in the vicinity of a hearth where a plasma beam enters is adjusted, allowing uniform film formation on large-area substrates.

Tablets for ion plating used for formation of transparent conductive films are, as sputtering targets, preferably sintered oxides. Use of sintered oxides allows stable production of transparent conductive films having consistent film thickness and consistent properties. However, unlike sputtering targets, tablets for ion plating have a sintered density of as low as about 70% as described in Non Patent Literature 1 in order to avoid damages by electron beam heating. When tablets for ion plating have excessively high or low density, sintered oxides may easily have cracks or breakage and be damaged.

Sintered oxide tablets are also required to uniformly evaporate, and thus it is preferable that the tablets do not contain a substance which has stable chemical bonds and thus hardly evaporates coexisting with a material which easily evaporates and exists in a main phase.

In addition, a method wherein an evaporating material (tablet) which is a sintered oxide is allowed to evaporate by ion plating to ionize and form a thin film has a problem in that splashing of the evaporating material during heating causes pin-hole defects on a deposited film due to scattered particles. Splashing refers to the following phenomenon. Namely, when an evaporating material is heated under vacuum by irradiation of a plasma beam or an electron beam, the evaporating material is vaporized at a certain temperature and uniform evaporation in atomic status is initiated. Splashing is a phenomenon on this occasion in which droplets having a macroscopic size of from about a few µm to 1000 µm mixed in uniform evaporated gas are ejected from the evaporating material and collide with a deposited film. This phenomenon causes pin-hole defects on deposited films due to collision of droplets and not only deteriorates homogeneity of deposited films but also significantly deteriorates the performance of conductive films.

As described above, in order to form transparent conductive films of oxides such as ITO by ion plating, use of oxide tablets which cause less splashing of evaporating materials during heating and do not cause pin-hole defects on deposited films due to scattered particles is important.

Patent Literature 2 discloses that, in order to improve weather resistance of a photovoltaic element, it is effective that the photovoltaic element comprises a transparent conductive film containing an indium oxide film having an orientation of (222) and two X-ray diffraction peaks, wherein the two X-ray diffraction peaks of the indium oxide film contain a first peak at a low angle side and a second peak at a high angle side having a peak intensity that is lower than that of the first peak. Patent Literature 2 further discloses that a transparent conductive film having the above X-ray diffraction peaks can be obtained by ion plating using a target including a sintered ITO of In₂O₃ powder containing about 1 to about 5 wt% of SnO₂ powder.

Accordingly ion plating allows formation of photovoltaic elements, i.e., transparent conductive films excellent for applications for solar cells. However, unlike sputtering targets, ITO sintered oxides suitable for ion plating have not been sufficiently studied.

Therefore the present applicant has proposed Patent Literature 4 which pertains to an ITO pellet (also referred to as tablet) for deposition that allows formation of excellent transparent conductive films for solar cells by ion plating. Patent Literature 4 describes that the pellet contains indium oxide as a main component, formed of a sintered oxide containing a certain amount of tin and has an L* value according to the CIE 1976 colorimetric system of 54 to 75. Thereby an oxide deposition material that allows stable production of a transparent conductive film having low resistance and high light transparency even with low oxygen amount introduced during film formation and the transparent conductive film produced with the oxide deposition material can be provided.

Patent Literature 3 proposes an ITO pellet for deposition and a production method thereof. Patent Literature 3 discloses that an ITO pellet for deposition which is not broken even with irradiation of a high power electron beam is preferably the one which is obtained by re-sintering granules having a particle diameter of 0.5 mm or less obtained by grinding a sintered ITO having a relative density of 90% or more and has a relative density of 60% or more and 80% or less. Patent Literature 3 indicates that the density of the sintered substance after sintering twice is adjusted to be low by using the granules which have been sintered once, in other words, the granules having decreased sintering ability. However, Patent Literature 3 does not propose any technique to control the density by sintering once, and thus has a disadvantage of an increased cost. In addition, Patent Document 3 discloses that by merely decreasing the density of the sintered ITO pellet, damages on the ITO pellet by electron beam irradiation can be reduced.

However, although not only reduction in the density of the sintered substance but also control of the texture of the sintered substance is indeed required in order to improve the strength, Patent Literature 3 and 4 do not specifically disclose on this point.

As described above, in conventional production techniques of sintered oxides containing indium and tin, prevention of cracks and breakage or splashing in deposition or ion plating has not been sufficiently studied. Thus there is a need for a sintered oxide containing indium and tin that can solve the above problems and has relatively low density and sufficient strength.

### CITATION LIST

### PATENT LITERATURE

Patent Literature 1: Japanese Patent Application Laid-open No. H08-232060
Patent Literature 2: Japanese Patent Application Laid-open No. 2007-194447
Patent Literature 3: Japanese Patent Application Laid-open No. H11-100660
Patent Literature 4: Japanese Patent Application Laid-open No. 2011-202246

### NON PATENT LITERATURE

Non Patent Literature 1: *"*Tomei dodenmaku no gijyutsu (Technique for transparent conductive films), 2nd edition", Ohmsha, Ltd. 20 December 2006, p..243-250

### SUMMARY OF INVENTION

### TECHNICAL PROBLEM

With the foregoing problems in view, an object of the present invention is to provide a tablet for ion plating which allows prevention of cracks and breakage or splashing during formation at high speed of crystalline transparent conductive films optimal for devices such as solar cells and a sintered oxide optimal for providing the tablet.

### SOLUTION TO PROBLEM

In order to solve the above problems, the present inventor has prepared various sintered oxide specimens having altered constituting phases and textures of sintered oxides containing indium oxide as a main component and tin as an additive element, processed the specimens into oxide tablets, formed by ion plating oxide transparent conductive films and investigated in detail how the constituting phases and textures of the sintered oxides affect the production conditions such as film formation speed or production of cracks and breakage or splashing during ion plating.

As a result, the present inventor has found that when an oxide tablet is used that is a sintered oxide (1) including indium oxide as a main component and tin as an additive element and having a tin content in the sintered oxide of 0.001 to 0.15 in terms of the atomic ratio of Sn/ (In+Sn), (2) wherein the sintered oxide includes crystal grains (A) having a tin content that is less than the tin content of the sintered oxide (hereinafter also referred to as average tin content of the sintered oxide) and crystal grains (B) having a tin content that is at or above the average tin content of the sintered oxide, and (3) has a density of 3.4 to 5.5 g/cm³, production of cracks and breakage or splashing which have been conventionally generated during ion plating can be suppressed even when the power supplied during formation of transparent conductive films is increased in order to increase the film formation speed, and as a result crystalline transparent conductive films having low specific resistance and high infrared light transmittance can be effectively and stably obtained, thereby completing the present invention.

Thus according to the first aspect of the present invention, there is provided a sintered oxide including indium oxide as a main component and tin as an additive element, and having a tin content of 0.001 to 0.15 in terms of an atomic ratio of Sn/(In+Sn), wherein the sintered oxide mainly includes crystal grains (A) having a tin content that is less than the average tin content of the sintered oxide and crystal grains (B) having a tin content that is at or above the average tin content of the sintered oxide, the difference in the average tin content between the crystal grains (B) and the crystal grains (A) being 0.015 or more in terms of the atomic ratio of Sn/(In+Sn), and has a density of 3.4 to 5.5 g/cm³.

According to the second aspect of the present invention, there is provided a sintered oxide including indium oxide as a main component and tin as an additive element, and further including one or more metal elements (M elements) selected from the group of metal elements consisting of titanium, zirconium, hafnium, molybdenum and tungsten as an additive element and having a total content of tin and the M element(s) of 0.001 to 0.15 in terms of an atomic ratio of (Sn+M)/(In+Sn+M), wherein the sintered oxide includes crystal grains (A) having at least a tin content that is less than the average tin content of the sintered oxide and crystal grains (B) having at least a tin content that is at or above the average tin content of the sintered oxide, the difference in the average tin content between the crystal grains (B) and the crystal grains (A) being 0.015 or more in terms of an atomic ratio of Sn/(In+Sn+M), and has a density of 3.4 to 5.5 g/cm³.

According to the third aspect of the present invention, there is provided the sintered oxide according to the first or second aspect, having a tin content of 0.003 to 0.05 in terms of the atomic ratio of Sn/(In+Sn).

According to the fourth aspect of the present invention, there is provided the sintered oxide according to the second aspect, having the total content of tin and the M element(s) of 0.003 to 0.05 in terms of the atomic ratio of (Sn+M)/(In+Sn+M).

According to the fifth aspect of the present invention, there is provided the sintered oxide according to the first or second aspect, wherein the crystal grains (A) have a tin content that is at or less than 4% by atom in average and the crystal grains (B) have a tin content that is at or above 25% by atom in average.

According to the sixth aspect of the present invention, there is provided the sintered oxide according to the first or second aspect, wherein the crystal grains (A) and the crystal grains (B) contain tin in the form of solid solution and include an In₂O₃ phase of bixbyite-type structure.

According to the seventh aspect of the present invention, there is provided the sintered oxide according to the first or second aspect, further including, in addition to the crystal grains (A) and the crystal grains (B), crystal grains (C) including an indium stannate compound phase.

According to the eighth aspect of the present invention, there is provided the sintered oxide according to the first or second aspect devoid of crystal grains (D) including a tin oxide phase.

### ADVANTAGEOUS EFFECTS OF INVENTION

Further, according to the ninth aspect of the present invention, there is provided a tablet obtained by processing the sintered oxide according to any of the first to eighth aspects.

The sintered oxide of the present invention containing indium and tin has a tin content in the sintered oxide of 0.001 to 0.15 in terms of the atomic ratio of Sn/(In+Sn), mainly includes crystal grains (A) having a tin content that is less than the average tin content of the sintered oxide and crystal grains (B) having a tin content that is at or above the average tin content of the sintered oxide, the difference in the average tin content between the crystal grains (B) and the crystal grains (A) being 0.015 or more in terms of the atomic ratio of Sn/(In+Sn), and has a density of 3.4 to 5.5 g/cm³, and thereby allows suppression of generation of cracks and breakage or splashing during ion plating even with an increased film formation speed upon production of oxide transparent conductive films using a tablet obtained by processing the sintered oxide. Accordingly an inefficient step in conventional methods can be carried out under film formation conditions with an increased film formation speed, and thus mass production of transparent conductive films is possible.

As a result, it is possible to effectively produce transparent conductive films containing indium and tin which are optimal for solar cells and the like, and thus the present invention is significantly useful in industrial fields.

### BRIEF DESCRIPTION OF DRAWINGS

Fig. 1 corresponds to a secondary electron image obtained by EPMA observation of the texture of the fracture surface of the sintered oxide of the present invention having the atomic ratio of Sn/(In+Sn) of 0.09, and the result of point analysis of the crystal grain composition; and
Fig. 2 is a chart showing the result of phase identification by X-ray diffractometry of the sintered oxide of the present invention having the atomic ratio of Sn/(In+Sn) of 0.09.

### DESCRIPTION OF EMBODIMENTS

The sintered oxide, the tablet for ion plating and production methods thereof of the present invention are hereinafter specifically described by referring to the drawings.

### 1. Sintered oxide

The sintered oxide of the present invention containing an oxide of indium and tin has a specific phase structure, and includes two types of sintered oxides: one has a tin content of 0.001 to 0. 15 in terms of the atomic ratio of Sn/(In+Sn) (which is hereinafter referred to as first sintered oxide) and the other includes, in addition to indium and tin, an M element and has a total content of tin and the M element of 0.001 to 0.15 in terms of the atomic ratio of (Sn+M)/(In+Sn+M), the M element being one or more metal elements selected from the group of metal elements consisting of titanium, zirconium, hafnium, molybdenum and tungsten (which is hereinafter referred to as second sintered oxide).

As described above, for formation of transparent conductive films including an oxide of indium and tin, sintered oxides mainly designed for sputtering targets have been conventionally proposed. However for ion plating, a material thereof, that is a sintered oxide containing indium and tin, has not been sufficiently studied in terms of optimization of the constituting phases, textures or density of the sintered oxide. Thus when such a sintered oxide is used in ion plating for production of oxide transparent conductive films, production of cracks and breakage or splashing could not be suppressed, making stable and high-speed production of the transparent conductive films difficult. In the present invention, the sintered oxide containing indium and tin is studied in detail in terms of the constituting phases and textures thereof to reveal the effect thereof on the film formation speed of oxide transparent conductive films and the effect thereof on production of cracks and breakage or splashing during film formation by ion plating.

### 1) First sintered oxide

The first sintered oxide of the present invention contains indium and tin as an oxide, has a tin content of 0.001 to 0.15 in terms of the atomic ratio of Sn/(In+Sn), includes crystal grains (A) having a tin content that is less than the average tin content of the sintered oxide and crystal grains (B) having a tin content that is at or above the average tin content of the sintered oxide, the difference in the average tin content between the crystal grains (B) and the crystal grains (A) being 0.015 or more in terms of the atomic ratio of Sn/(In+Sn), and has a density of 3.4 to 5.5 g/cm³.

### (a) Composition

The first sintered oxide of the present invention is required to have a tin content of 0.001 to 0.15 in terms of the atomic ratio of Sn/(In+Sn). The tin content is preferably 0.002 to 0.10, more preferably 0. 003 to 0.05 and particularly preferably 0.005 to 0.03. The sintered oxide having a tin content within the range allows, after being processed to a tablet for ion plating, production of a crystalline transparent conductive film which is suitable for solar cells and has low specific resistance and high near-infrared transmittance.

The tin content of less than 0.001 in terms of the atomic ratio of Sn/(In+Sn) is not preferable because minimum required carrier electrons are not produced in the transparent conductive film formed from the sintered oxide. The tin content of the sintered oxide of, to the contrary, above 0.15 in terms of the atomic ratio of Sn/(In+Sn) is not preferable because excess Sn behaves as impurity ion scattering centers in the formed crystalline transparent conductive film, resulting in a rather increased specific resistance. The near-infrared transmittance is important for transparent conductive films for solar cells and thus it is important that the carrier electron density and mobility are adjusted in a balanced manner. In this context, the tin content is preferably 0.002 to 0.10 and more preferably 0.003 to 0.05 in terms of the atomic ratio of Sn/(In+Sn). Unavoidable impurities may be contained at the amount that does not affect the above properties, for example, at 500 ppm or less.

### (b) Generated phases and configuration thereof

The texture of the first sintered oxide mainly includes crystal grains (A) having a tin content that is less than the average tin content of the sintered oxide and crystal grains (B) having a tin content that is at or above the average tin content of the sintered oxide and may include crystal grains (C) including an indium stannate compound phase.

When crystal grains in the first sintered oxide only include crystal grains (B) having a tin content that is at or above the average tin content of the sintered oxide, the first sintered oxide may have poor sintering ability. As described above, tablets for ion plating are required to have a sintered density as low as around 70% relative to the theoretical density of around 7 g/cm³ in order to avoid damages due to electron beam heating, for example. Increasing crystal grains (B) having a tin content that is at or above the average tin content of the sintered oxide allows suppression of the sintered density down to around 70% and thus is effective for suppression of damages due to cracks and breakage or splashing. However, inclusion of only crystal grains (B) including the indium oxide phase having a tin content that is at or above the average tin content of the sintered oxide causes a problem of reduction in strength of the sintered substance. Decreasing the density of the sintered substance may relieve the impact by electron beam heating in some extent; however it may decrease the strength of the sintered substance, thereby resulting in insufficient impact resistance. The sintered oxide of the ITO pellet for deposition disclosed in Patent Literature 3 exactly corresponds to this case.

On the other hand, when the sintered oxide is formed with only crystal grains (A) having a tin content that is less than the average tin content of the sintered oxide, it is advantageous because the sintered oxide has excellent sintering ability compared to the sintered oxide formed with only crystal grains (B) having an amount of tin in the form of solid solution that is at or above the average tin content of the sintered oxide. In this case, the density of the sintered substance is as high as above around 70% described above; however the strength of the sintered substance may be increased.

The present invention which takes the above into account is to solve the problem by configuring the texture of the first sintered oxide of the present invention by including crystal grains (A) having a tin content that is less than the average tin content of the sintered oxide and crystal grains (B) having a tin content that is at or above the average tin content of the sintered oxide in combination. Thus the present invention intends to increase the performance of the tablet for ion plating with the crystal grains (B) including the indium oxide phase having a tin content that is at or above the average tin content of the sintered oxide which control the sintered density at as relatively low as around 70% thanks to poor sintering ability thereof and the crystal grains (A) including the indium oxide phase having a tin content that is less than the average tin content of the sintered oxide which maintain the strength of the sintered substance thanks to excellent sintering ability thereof.

In order to achieve this, it is required that the difference in the average tin content between the crystal grains (B) and the crystal grains (A) be 0.015 or more, preferably 0.020 or more and more preferably 0.040 or more in terms of the atomic ratio of Sn/ (In+Sn). For example, mention may be made of the sintered oxide wherein the difference in the average tin content is 0.015 or more, and the crystal grains (A) have an average tin content of 0.010 or less and the crystal grains (B) have an average tin content of 0.015 or more, or crystal grains (A) have an average tin content of 0.01 or less and the crystal grains (B) have an average tin content of 0.03 or more, or the crystal grains (A) have an average tin content of 0. 03 or less and the crystal grains (B) have an average tin content of 0.05 or more, or the crystal grains (A) have an average tin content of 0.04 or less and the crystal grains (B) have an average tin content of 0.10 or more, which may be preferably used.

The sintered oxide mainly including the crystal grains (A) and (B) preferably contains tin in the form of solid solution and includes crystal grains including an In₂O₃ phase of bixbyite-type structure.

The crystal grains may include, other than the In₂O₃ phase of bixbyite-type structure, crystal grains (C) including an indium stannate compound phase. The indium stannate compound refers to, for example, the In₄Sn₃O₁₂ compound described in JCPDS card #01-088-0773 or similar compounds with constant proportions. The indium stannate compound phase has poor sintering ability as the crystal grains (B) having a tin content that is at or above the average tin content of the sintered oxide, and thus can control the sintered density to relatively low as around 70%. It is sufficient that the indium stannate compound phase maintains the crystal structure even when it has the composition slightly departed from the stoichiometric composition or even when other ions are partly substituted.

It is not preferable that the sintered oxide of the present invention contains crystal grains (D) including a tin oxide phase; however a small amount of the crystal grains (D) including the tin oxide phase may not interfere with the stable formation of crystalline transparent conductive films. A small amount of the crystal grains (D) including the tin oxide phase may be indicated by, for example, the analysis of an EPMA image in which the area ratio of the crystal grains (D) including the tin oxide phase, namely the crystal grain only containing tin and oxygen without indium, relative to all crystal grains is 5% or less. However inclusion of the crystal grains (D) including the tin oxide phase may be disadvantageous in that the film formation speed is decreased in some extent during film formation by ion plating, although the film properties may not be significantly different compared to the case where the crystal grains (D) including the tin oxide phase are not included.

### (c) Texture of sintered substance

The sintered oxide of the present invention has the texture that may cause decreased cracks and breakage or splashing during film formation by ion plating.

When the sintered oxide containing indium and tin as an oxide is processed to form, for example, a tablet for ion plating, the crystal grains (A) having a tin content that is less than the average tin content of the sintered oxide and the crystal grains (B) having a tin content that is at or above the average tin content of the sintered oxide exist on or in the tablet. The crystal grain diameter of either of grains is not particularly limited.

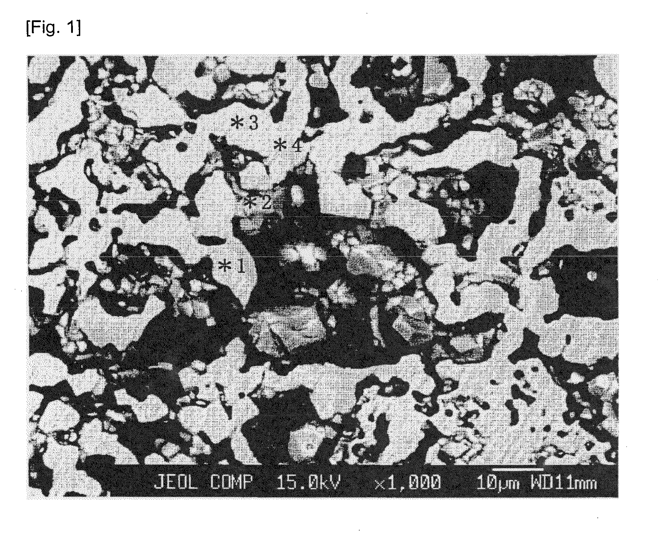

Fig. 1 shows the result of point analysis with an electron probe microanalyzer (EPMA) for the crystal grain composition observed on the polished fracture surface of an exemplary sintered oxide containing tin at the amount of 0.09 in terms of the atomic ratio of Sn/(In+Sn). Although it is difficult to distinguish because it is the polished surface, different crystal grains respectively labelled with *1 and *2, and *3 and *4 are observed in Fig. 1. Examination of the crystal grains for the tin atomic ratio represented by Sn/(In+Sn) reveals that *1 and *3 are less than the average tin content of the sintered oxide and *2 and *4 are at or above the average tin content of the sintered oxide.

The sintered oxide having the texture as shown in Fig. 1 may have an increased strength because the crystal grains (A) having a tin content that is less than the average tin content of the sintered oxide have excellent sintering ability as described above. At the same time, because the crystal grains (B) having a tin content that is more than or equal to the average tin content of the sintered oxide have poor sintering ability, the sintered substance can have a decreased density, securing the impact resistance as a result. The crystal grain diameter obtained in Fig. 1 was 1 µm or more; the crystal grain diameter is 1 µm or more in most cases even when the conditions are varied.

As repetitively described above, it is apparent that the above described texture is effective for suppression of cracks and breakage or splashing during film formation by ion plating. By configuring the sintered oxide with two types of crystal grains, i.e. the crystal grains (A) having a tin content that is less than the average tin content of the sintered oxide and having excellent sintering ability and the crystal grains (B) having a tin content that is at or above the average tin content of the sintered oxide and having poor sintering ability, the strength can be secured as well as the density of the sintered substance can be adjusted (decreased), resulting in suppression of cracks and breakage or splashing. In this case, by combining two types of crystal grains, the density is controlled in the range of 3.4 to 5.5 g/cm³. The density is more preferably in the range of 4.5 to 5.1 g/cm³.

### 2) Second sintered oxide

The second sintered oxide of the present invention contains, in addition to the first sintered oxide, one or more metal elements (M elements) selected from the group of metal elements consisting of titanium, zirconium, hafnium, molybdenum and tungsten as an oxide and has a total content of tin and the M element (s) of 0.001 to 0.15 in terms of the atomic ratio of (Sn+M)/(In+Sn+M).

Addition of tin to a transparent conductive film containing indium oxide as a main component is extremely effective for production of carrier electrons. However the produced carrier electrons have decreased mobility as the carrier electron density increases. Low carrier electron density means high transmittance in the infrared range and is preferable for devices utilizing infrared light such as solar cells.

Thus in order to specialize the transparent conductive film of the present invention for solar cell application, it is important that the required carrier electron density is secured and the mobility of the carrier electrons is increased, and the transparent conductive film has the composition of the total content of tin and the M element (s) of preferably 0.002 to 0.10 and more preferably 0.003 to 0.05 in terms of the atomic ratio of (Sn+M)/(In+Sn+M).

Elements which allow high mobility of carrier electrons may include titanium, zirconium, hafnium, molybdenum and tungsten.

In this case, it is required that the total content of tin and the M element(s) is 0.001 to 0.15 in terms of the atomic ratio of (Sn+M)/(In+Sn+M). The total content of tin and the M element(s) is preferably 0.002 to 0.10 and more preferably 0.003 to 0.05. For any M element, the total content of less than 0.001% by atom is not preferable because the minimum required carrier electrons are not produced in the transparent conductive film formed therefrom. On the other hand, for any M element, the atomic ratio of above 0.15 causes a rather increased specific resistance in the crystalline transparent conductive film formed because excess Sn and M element (s) behave as impurity ion scattering centers, making it difficult to apply the crystalline transparent conductive film to transparent electrodes of solar cells.

Elements other than tin such as silicon, germanium, antimony, bismuth and tellurium may exist, in spite of a slightly decreased effect thereof for production of carrier electrons compared to tin, as unavoidable impurities at 500 ppm or less.

It is preferable that the second sintered oxide of the present invention have similar generated phases and texture as the first sintered oxide. Thus the second sintered oxide is characterized in that the sintered oxide includes indium oxide as a main component, tin as an additive element and one or more metal elements (M elements) selected from the group of metal elements consisting of titanium, zirconium, hafnium, molybdenum and tungsten as an additive element and has a total content of tin and the M element (s) of 0.001 to 0.15 in terms of the atomic ratio of (Sn+M)/(In+Sn+M), wherein the sintered oxide includes crystal grains (A) having at least a tin content that is less than the average tin content of the sintered oxide and crystal grains (B) having at least a tin content that is at or above the average tin content of the sintered oxide, the difference in the average tin content between the crystal grains (B) and the crystal grains (A) being 0.015 or more in terms of the atomic ratio of Sn/(In+Sn+M), and has a density of 3.4 to 5.5 g/cm³.

Any of the one or more metal elements (M elements) selected from the group of metal elements consisting of titanium, zirconium, hafnium, molybdenum and tungsten is contained in the crystal grains (A) having a tin content that is less than the average tin content of the sintered oxide or the crystal grains (B) having a tin content that is at or above the average tin content of the sintered oxide. The M element does not significantly affect the sintering ability of the sintered oxide regardless of the tin content that may be less than or at or above the average tin content of the sintered oxide. For example, the crystal grains (A) having a tin content that is less than the average tin content of the sintered oxide still have rather excellent sintering ability even when the crystal grains (A) contain the M element. Similarly, the crystal grains (B) having a tin content that is at or above the average tin content of the sintered oxide still have rather poor sintering ability even when the crystal grains (B) contain the M element. Thus the M element may be contained in the crystal grains (A) having a tin content that is less than the average tin content of the sintered oxide, in the crystal grains (B) having a tin content that is at or above the average tin content of the sintered oxide or in both.

In the second sintered oxide of the present invention, the difference in the average tin content between the crystal grains (B) and the crystal grains (A) is 0.015 or more, preferably 0.02 or more and more preferably 0.025 or more in terms of the atomic ratio of Sn/(In+Sn+M).

Further, mention may be made of the one including the crystal grains (A) having an average tin content of 0.010 or less and the crystal grains (B) having an average tin content of 0.015 or more, and the one including the crystal grains (A) having an average tin content of 0. 005 or less and the crystal grains (B) having an average tin content of 0.02 or more is particularly preferable.

Thus, the second sintered oxide is the sintered oxide containing indium, tin and one or more metal elements (M elements) selected from the group of metal elements consisting of titanium, zirconium, hafnium, molybdenum and tungsten as an oxide, wherein the sintered oxide has a total content of tin and the M element of 0.001 to 0.15 in terms of the atomic ratio of (Sn+M)/(In+Sn+M) and includes crystal grains (A) having at least a tin content that is less than the average tin content of the sintered oxide and crystal grains (B) having at least a tin content that is at or above the average tin content of the sintered oxide. By configuring the sintered oxide with two types of crystal grains of the crystal grains (A) having a tin content that is less than the average tin content of the sintered oxide and having excellent sintering ability and the crystal grains (B) having a tin content that is at or above the average tin content of the sintered oxide and having poor sintering ability, the strength can be secured as well as the density of the sintered substance can be adjusted (decreased), resulting in suppression of cracks and breakage or splashing.

In this case, by controlling the ratio between two crystal grains combined, the density is controlled in the range of 3.4 to 5.5 g/cm³. The density is preferably in the range of 4.5 to 5.1 g/cm³.

Similar to the first sintered oxide, the sintered oxide including the above crystal grains (A) and (B) preferably contains tin in the form of solid solution, includes crystal grains including an In₂O₃ phase of bixbyite-type structure, and may include, as a phase other than this, crystal grains (C) including an indium stannate compound phase. It is also similar to the first sintered oxide that the sintered oxide preferably does not contain crystal grains (D) including a tin oxide phase.

### 2. Production method of sintered oxides

The starting materials for the sintered oxides of the present invention are indium oxide powder and tin oxide powder or further oxide powder of one or more metal elements (M elements) selected from the group of metal elements consisting of titanium, zirconium, hafnium, molybdenum and tungsten. These powders are appropriately mixed, subjected to calcination, granulation and molding and the molded material is sintered by pressureless sintering. Alternatively the powders are granulated and molded and sintered by hot pressing. Pressureless sintering is simple and industrially advantageous and thus is a preferable means; however hot pressing may also be used, if necessary.

### 1) Pressureless sintering

When pressureless sintering is used for obtaining the sintered oxides in the present invention, a molded article is first prepared.

In order to produce the first sintered oxide, starting material powders of indium oxide powder and tin oxide powder are respectively weighed so as to achieve a desired composition. Starting powders preferably have an average particle diameter of 3 µm or less and more preferably 1.5 µm or less. Particularly by controlling the average particle diameter of indium oxide, sufficient sintering ability may be secured. As a result, the crystal grains (A) having a tin content that is less than the average tin content of the sintered oxide secure necessary and sufficient strength of the sintered oxide suitable for a tablet for ion plating.

Among the weighed indium oxide powder, 20 to 95% by weight of indium oxide powder and the total amount of the weighed tin oxide powder are first placed in a resin pot and subjected to primary mixing with a dispersing agent, a binder (e.g., PVA may be used) and the like in a wet ball mill or a bead mill. The mixing time is preferably 10 hours or more and particularly 15 hours or more. Balls or beads for mixing may be ceramic balls such as hard ZrO₂ balls. After mixing, slurry is removed, filtered and dried to obtain mixed powder. The amount of indium oxide powder mixed with tin oxide powder is more preferably 20 to 85% by weight, still more preferably 30 to 75% by weight and particularly preferably 40 to 65% by weight.

When the proportion of indium oxide powder mixed with the weighed tin oxide powder is less than 20% by weight of the weighed indium oxide, a problem may be caused in that an indium stannate compound phase may easily be produced. When the proportion of indium oxide powder is above 95% by weight, the amount of the crystal grains (A) subsequently formed may be excessive and thus, although necessary and sufficient strength may be secured, it is difficult to control the sintered density at about 70%.

The obtained primary mixed powder is calcinated to form the crystal grains (B) having a tin content that is at or above the average tin content of the sintered oxide. Calcination is carried out by heating in a gas flow heating furnace or a vacuum heating furnace in an atmospheric or oxygen atmosphere or under vacuum at a temperature from 800°C or higher to 1500°C or less for 10 hours or more. In case of the first sintered oxide for example, calcinating promotes mixing of tin in the form of solid solution with indium oxide or production of the indium stannate compound phase before sintering. The calcinating conditions are preferably a temperature from 900°C or higher to 1400°C or lower for 12 hours or more.

When the heating temperature is lower than 800°C, a problem arises in that calcination may not sufficiently progress, and when the temperature is higher than 1500°C, a problem arises in that sintering may precede. In the stage of calcination, most of particles are in point contact and are not sufficiently bonded.

Meanwhile among the weighed indium oxide powder, the residual indium oxide powder (5 to 80% by weight) forms, through the subsequent sintering step and the like, the crystal grains (A) having a tin content that is less than the average tin content of the sintered oxide. The indium oxide powder may be calcinated under the same condition as the primary mixed powder, if necessary. By calcinating the residual indium oxide powder, progress of sintering *per se* in the subsequent sintering or mixing of tin in the form of solid solution with indium oxide may be suppressed. Tin is intrinsically difficult to be diffused in indium oxide, unlike metal elements such as titanium. Thus even when the residual indium oxide powder is not calcinated, tin in the form of solid solution may not be released from the calcinated primary mixed powder or an indium stannate compound may not be produced. In contrast, a metal element such as titanium is easily diffused in indium oxide and thus in case of non-calcination, the metal element in the form of solid solution may be easily mixed with the residual indium oxide powder in the subsequent sintering.

Namely in case of the second sintered oxide, oxide powder of the group of metal elements consisting of titanium, zirconium, hafnium, molybdenum and tungsten which is added together may be added to mixed powder, the residual indium oxide powder or both before calcination.

After the above steps, the calcinated powder and the residual indium oxide powder (non-calcinated powder) are secondarily mixed in the similar manner as above over 1 to 24 hours. The obtained secondary mixed powder is filtered, dried and then granulated. The mixing time of as short as 1 hour or less is not preferable because the crystal grains (A) and the crystal grains (B) may easily have uneven distribution after sintering.

Subsequently the obtained granulated powder is molded on a uniaxial press or a cold isostatic press at pressure of about 4.9 MPa (50 kg/cm²) to 196 MPa (2000 kg/cm²) to obtain a molded article. In this stage, particles which have been in point contact after calcination become in surface contact.

The calcinated powder preferably has an average particle diameter of 3 µm or less and more preferably 1.5 µm or less. Particularly by controlling the average particle diameter of indium oxide, sufficient sintering ability may be secured. As a result, the crystal grains (A) having a tin content that is less than the average tin content of the sintered oxide secure necessary and sufficient strength of the sintered oxide suitable for a tablet for ion plating.

In a sintering step in pressureless sintering, heating to a predetermined temperature range is carried out in an atmosphere containing oxygen. In order to obtain a sintered oxide suitable for a tablet for ion plating, the molded article is preferably sintered in an atmosphere containing oxygen at 1000 to 1500°C for 10 to 30 hours. More preferably the molded article is sintered in an atmosphere in a sintering furnace containing air and introduced oxygen gas at 1100 to 1400°C. The time of sintering is preferably 15 to 25 hours. The sintering temperature and the sintering time are preferably higher and longer than the calcination in order to promote diffusion of powder particles and promote sintering.

When the sintering temperature is too low, sintering reaction may not sufficiently progress. Particularly in order to obtain the sintered oxide having a density as relatively high as 3.4 g/cm³ or more, the sintering temperature is desirably 1000°C or higher. When the sintering temperature exceeds 1500°C, the sintered oxide may have a density above 5.5 g/cm³.

The sintering atmosphere preferably contains oxygen and is further preferably an atmosphere in a sintering furnace containing air and introduced oxygen gas. Presence of oxygen during sintering can increase the density of the sintered oxide. In order to prevent breakage of the sintered substance and promote extraction of binders, it is preferable that the heating rate to the sintering temperature is in the range of 0.2 to 5°C/min. If necessary, different heating rates may be combined in order to attain the sintering temperature. During heating, a specific temperature may be held for a certain amount of time in order to promote extraction of binders and sintering. After sintering, cooling may be carried out after termination of introduction of oxygen to 1000°C at a rate of 0.2 to 10°C/min, 0.2 to 5°C/min and particularly the cooling rate is preferably in the range of 0.2°C to 1°C/min.

### 2) Hot pressing

When hot pressing is used for production of the sintered oxide in the present invention, unlike pressureless sintering, the secondary mixed powder obtained after calcinating is molded and sintered in an inert gas atmosphere or under vacuum under pressure of 2.45 to 29.40 MPa at 700 to 950°C for 1 to 10 hours. Hot pressing allows, compared to pressureless sintering described above, reduction of oxygen content in the sintered substance because the material powder is molded and sintered in a reduced atmosphere without oxygen. However, molding and sintering at a temperature as high as above 950°C may reduce indium oxide and metallic indium melts away, and thus caution is required.

Exemplary production conditions upon production of the sintered oxides of the present invention by hot pressing are hereinafter described. The starting material powders preferably have, from the same reasons as pressureless sintering, an average particle diameter of 3 µm or less and more preferably 1.5 µm or less.

After calcination in the same manner as for pressureless sintering, the secondary mixed powder and then the granulated powder is obtained. The granulated mixed powder is supplied in a carbon container and sintered by hot pressing. The sintering temperature may be 700 to 950°C, pressure may be 2.45 MPa to 29.40 MPa (25 to 300 kgf/cm²) and the sintering time may be around 1 to 10 hours. The atmosphere during hot pressing is preferably an inert gas atmosphere such as argon or under vacuum.

### 3. Tablet for ion plating

The sintered oxides of the present invention are cut into certain dimensions and subjected to surface polishing to obtain a tablet for ion plating.

The tablet for ion plating has a density of 3.4 to 5.5 g/cm³. When the density is below 3.4 g/cm³, the sintered substance itself has defective strength, so that cracks and breakage may be easily produced even with a slight local thermal expansion. When the density is above 5.5 g/cm³, stress and strain locally generated during application of a plasma beam or an electron beam cannot be absorbed, and thus cracks may be easily produced and film formation at high speed may be difficult. The density is preferably 3.8 to 5.3 g/cm³ and more preferably 4.5 to 5.1 g/cm³. In the present invention, by adjusting (decreasing) the density during production of the sintered oxide, the texture of the tablet contains an opening (void).

Although the diameter or the thickness of the tablet is not particularly limited, it is required that it has a shape compatible to the ion plating device to be used. Generally a cylindrical shape is frequently used and the one with a diameter of 20 to 50 mm and a height of about 30 to 100 mm is preferred.

The tablet for ion plating may also serve as a table for vacuum deposition.

### 4. Transparent conductive film and formation method thereof

In the present invention, the tablet for ion plating obtained by processing the sintered oxide may be used to mainly form a crystalline transparent conductive film on a substrate.

The substrate may be various plates or films according to applications such as glass, synthetic quartz, synthetic resins such as PET and polyimide and stainless plates. Particularly when a crystalline transparent conductive film is formed which requires heating, the substrate is required to have heat resistance.

In ion plating, the direct current power applied is generally increased in order to improve the film formation speed of transparent conductive films. As described hereinabove, The first and second sintered oxides of the present invention include the crystal grains (A) having a tin content that is less than the average tin content of the sintered oxide and having excellent sintering ability and the crystal grains (B) having a tin content that is at or above the average tin content of the sintered oxide and having poor sintering ability.

Thus because the sintered oxides have both high strength and low density, cracks and breakage or splashing can be suppressed even when the direct current power applied is increased.

### 1) Film formation by ion plating

In ion plating, a tablet for ion plating (also referred to as pellet) is used to form a transparent conductive film on a substrate. The tablet for ion plating used is the one obtained by processing the sintered oxide of the present invention having a density of 3.4 to 5.5 g/cm³.

As described above, in ion plating, a tablet which is an evaporation source is irradiated with an electron beam or heat by arc discharge. The irradiated portion locally has an increased temperature, allowing evaporation of particles which are deposited on a substrate. The evaporated particles on this occasion are ionized by an electron beam or arc discharge. Ionization may be carried out by various methods; high density plasma assist deposition (HDPE) using a plasma generator (plasma gun) is suitable for formation of transparent conductive films having high quality. This method utilizes arc discharge using a plasma gun. Arc discharge is maintained between a cathode contained in the plasma gun and a crucible (anode) which is an evaporation source. Electrons released from the cathode are introduced into the crucible by means of magnetic deflection and are concentrated and applied locally on a tablet charged in the crucible. By means of the electron beam, particles are evaporated from the portion which locally has an increased temperature and deposited on a substrate. The evaporated particles which have been vaporized and O₂ gas introduced as reactant gas are ionized and activated in plasma, thereby transparent conductive films having high quality can be prepared.

In order to form a transparent conductive film, it is preferable that mixed gas of inert gas and oxygen, particularly argon and oxygen is used. It is also preferable that the chamber of the device has internal pressure of 0.1 to 3 Pa and more preferably 0.2 to 2 Pa.

In the present invention, film formation can be carried out at room temperature without heating the substrate. However, the substrate may be heated to 50 to 500°C and is preferably heated to 150 to 400°C. In case of application to a transparent electrode of solar cells for example, a crystalline transparent conductive film can be formed by maintaining the substrate at a temperature of 150 to 400°C.

### 2) Resulting transparent conductive film

By using the tablet for ion plating of the present invention as described above, an amorphous or crystalline transparent conductive film having excellent optical properties and conductivity can be formed on a substrate by ion plating at relatively high speed.

The resulting transparent conductive film has the composition which includes almost the same amount of indium and tin as the tablet for ion plating. The transparent conductive film containing indium and tin may further contain one or metal elements (M elements) selected from the group of metal elements consisting of titanium, zirconium, hafnium, molybdenum and tungsten.

The film thickness may vary according to the applications and may be 10 to 1000 nm. The amorphous transparent conductive film may be converted to a crystalline structure by heating in an inert gas atmosphere at 300 to 500°C for 10 to 60 minutes.

The crystalline transparent conductive film has a specific resistance which is calculated as a product of a surface resistance measured by four probe method with a resistivity meter and a film thickness of preferably 5.0 × 10⁻⁴ Ωcm or less and more preferably 3.0 × 10⁻⁴ Ωcm or less. A film may have a specific resistance of 5.0 × 10⁻⁴ Ωcm or less even when the film is amorphous depending on the composition of the film. The generated phases of the film can be identified by X-ray diffractometry and basically include only the indium oxide phase. The film also shows a transmittance corresponding to an average transmittance in the visible region of 80% or more and 85% or more in most cases. For applications of surface electrodes of solar cells, the transmittance in the infrared range is also required; the transparent conductive film formed with the tablet for ion plating of the present invention is preferable and has a transmittance of 80% or more and suitably 85% or more at a wavelength of 1200 nm for example. The transmittance as high as 85% or more is achieved with the transparent conductive film having a total content of tin and the M element (s) of 0.03 or less in terms of the atomic ratio of (Sn+M)/(In+Sn+M).

The crystalline or amorphous transparent conductive film formed with the tablet for ion plating of the present invention can be similarly formed by deposition.

### EXAMPLES

The present invention is hereinafter specifically described by way of Examples and Comparative Examples which do not limit the present invention.

### (Evaluation of sintered oxides)

The density of the obtained sintered oxides was measured by the Archimedes' method using scraps. The generated phases of the sintered oxides were identified by X-ray diffractometry (X'pert PRO MPD from Philips) and TEM analysis (HF-2200 from Hitachi High-Technologies Corporation) after grinding some of the scraps.

Some of the powder was used for compositional analysis of sintered oxides by ICP optical emission spectrometry. The sintered oxides were also subjected to observation of texture and point analysis using EPMA (JXA-8100 from JEOL Ltd.).

### (Evaluation of tablets)

In order to examine discharge stability of tablets during ion plating, 10 tablets were observed until they were unusable for generation of problems such as cracks and breakage or splashing. In Table 2, absence of problems such as cracks and breakage or splashing is indicated as "No" and generation of the problems during the film formation period is indicated as "Yes".

### (Evaluation of fundamental properties of transparent conductive films)

The composition of obtained transparent conductive films was examined by ICP optical emission spectrometry. The film thickness of the transparent conductive films was measured on a surface profilometer (Alpha-Step IQ, KLA-Tencor Corporation). The film formation speed was calculated from the film thickness and the film formation period. The specific resistance of the films was calculated as a product of the surface resistance measured by four probe method with a resistivity meter (Loresta Type EP MCP-T360, DIA Instruments Co., Ltd.) and the film thickness. The transmittance of the films was determined on a spectrophotometer (V-570, JASCO Corporation). The generated phases of the films were identified by X-ray diffractometry in the same manner as sintered oxides.

### (Example 1)

Starting material powders were indium oxide powder and tin oxide powder both of which had an average particle diameter of 1.5 µm or less. Both powders were weighed so as to obtain a tin content of 0.09 in terms of the atomic ratio of Sn/(In+Sn). Among these, 30% by weight of indium oxide powder and the total amount of tin oxide powder were placed in a resin pot together with water, a dispersing agent and the like and mixed in a wet ball mill. Hard ZrO₂ balls were used for mixing of 18 hours. After mixing, slurry was removed, filtered and dried to obtain primary mixed powder. The primary mixed powder was then calcinated in a sintering furnace with a heating rate of 1°C/min under the conditions of 1250°C and 10 hours. The residual indium oxide powder was not calcinated. The calcinated powder and the non-calcinated powder were then again mixed in a wet ball mill. After mixing, slurry was filtered and dried to obtain secondary mixed powder. The secondary mixed powder was then granulated. The granulated powder was then charged in a mold and molded on a uniaxial press while applying pressure of 9.8 MPa so as to have the shape of tablets. The tablet was molded so as to have the dimensions after sintering of 30 mm in diameter and 40 mm in height.

The molded articles were then sintered as follows. The molded articles were sintered in an atmosphere wherein oxygen was introduced to air in the sintering furnace at a rate of 5 liter/min per 0.1 m3 of the sintering furnace volume and at a sintering temperature of 1250°C for 20 hours. The heating rate was 1°C/min, and introduction of oxygen was terminated upon cooling after sintering to 1000°C at a cooling rate of 10°C/min.

The obtained sintered oxide was subjected to compositional analysis by ICP optical, emission spectrometry and found to have almost the same composition as the charged composition at the time of weighing of the starting material powders. Namely, the average tin content of the sintered oxide is almost the same as the charged composition at the time of weighing of the starting material powders. The sintered oxide was measured for the density which was found to be 4.94 g/cm³.

The sintered oxide was then subjected to the texture analysis by EPMA observation and the compositional analysis of crystal grains. The result of point analysis of the section of the sintered substance showed that, as shown in Fig. 1, there were crystal grains (*1 or *3 in the photograph) having a tin content that was less than the average tin content of the sintered oxide and crystal grains (*2 or *4 in the photograph) having a tin content that was at or above the average tin content of the sintered oxide. All crystal grains generally had a particle diameter of more than 1 µm.

*1 had In: 97.2 at% and Sn: 2.8 at%, *2 had In: 71.6 at% and Sn: 28.4 at%, *3 had In: 97.0 at% and Sn: 3.0 at% and *4 had In: 75.7 at% and Sn: 24.3 at%. Namely the crystal grains (A) had an average composition of In: 97.1 at% and Sn: 2.9 at% and the crystal grains (B) had an average composition of In: 73.6 at% and Sn: 26.4 at%. Accordingly the difference in the average tin content between the crystal grains (A) and the crystal grains (B) is 0.235 in terms of the atomic ratio represented by Sn/(In+Sn).

The results shown in Tables 1 and 2 revealed that the obtained sintered oxide mainly included the crystal grains (A) having a tin content that was less than the average tin content of the sintered oxide and the crystal grains (B) having a tin content that was at or above the average tin content of the sintered oxide and had a density of 3.4 to 5.5 g/cm³.

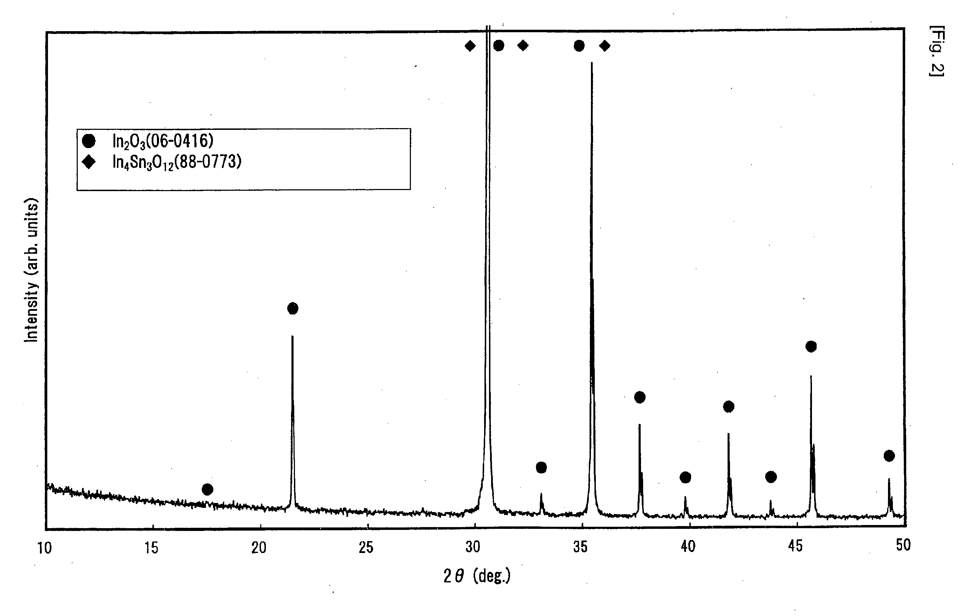

The obtained sintered oxide was subsequently subjected to phase identification by X-ray diffractometry. The measurement result is shown in Fig. 2. It was predicted from the EPMA result described above that the obtained sintered oxide included In₂O₃ phases (•) of bixbyite-type structure and In₄Sn₃O₁₂ phases ( 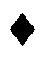 ) of the indium stannate compound, although conclusion was not made because the diffraction peaks of both phases overlapped. Thus TEM observation was carried out and an investigation made on electron diffraction images revealed that there were crystal grains of In₂O₃ phases of bixbyite-type structure and In₄Sn₃O₁₂ phases of the indium stannate compound.

From the above analysis results, it was concluded that the sintered oxide of the present Example mainly included the crystal grains (A) having a tin content that was less than the average tin content of the sintered oxide and the crystal grains (B) having a tin content that was at or above the average tin content of the sintered oxide and had a density of 3.4 to 5.5 g/cm³, wherein the crystal grains (A) and (B) contained tin in the form of solid solution and corresponded to either crystal grains including an In₂O₃ phase of bixbyite-type structure or crystal grains (C) including an indium stannate compound phase.

The sintered oxide was thereafter processed to obtain tablets which were subjected to continuous discharge using a plasma gun by ion plating until the tablets were unusable. The ion plating device used was a reactive plasma deposition apparatus for high density plasma assist deposition (HDPE). A film formation chamber included an arc plasma generator of low voltage (about 70 V) and high current (250 A) and a crucible for accommodation of a starting material (tablets). Thermal electrons released from the surface of a cathode in the plasma generator were guided by a magnetic field, thereby released in the chamber, concentrated and applied to the tablets in the crucible. Arc discharge is maintained between the cathode and an anode (crucible) by means of Ar gas introduced from the close vicinity of the cathode. Mixed gas of Ar and O₂ was introduced into the chamber and the degree of vacuum was 4 × 10⁻² Pa. In order to examine discharge stability of tablets, specifically 10 tablets were observed until they were unusable for generation of problems such as cracks and breakage or splashing, which did not result in generation of the problematic phenomena.

Film formation was carried out using fresh tablets. A transparent conductive film having a thickness of 200 nm was formed with a 7059 substrate from Corning at a substrate temperature of 300°C. It was found that the resulting transparent conductive film had the composition almost the same as that of the tablets.

The film was measured for the specific resistance which was found to be 1.7 × 10⁻⁴ Ωcm. The film was measured for the transmittance and it was found that the average transmittance of visible light was above 85% while the transmittance at a wavelength of 1200 nm was below 80%. The result of analysis of crystallinity of the film by X-ray diffractometry showed that the film was a crystalline film only including an indium oxide phase and that tin in the form of solid solution was mixed with the indium oxide phase.

### (Example 2)

A sintered oxide and then tablets for ion plating were prepared in the same manner as Example 1 except that starting material powders were weighed so as to obtain a tin content of 0.008 in terms of the atomic ratio represented by Sn/(In+Sn) and the proportion of indium oxide powder mixed with the total amount of the tin oxide powder was 50% by weight of the total indium oxide powder.

The obtained sintered oxide was subjected to compositional analysis by ICP optical emission spectrometry and was found to have almost the same composition as the charged composition at the time of weighing of the starting material powders. The sintered oxide was measured for the density which was found to be 4.88 g/cm³.

The sintered oxide was then subjected to the texture analysis by EPMA observation and the compositional analysis of crystal grains in the same manner as Example 1. The result of point analysis of the elemental distribution showed that there were crystal grains (A) having a tin content that was less than the average tin content of the sintered oxide and crystal grains (B) having an amount of tin in the form of solid solution that was at or above the average tin content of the sintered oxide. The crystal grains (A) had an average composition of In: 99.7 at% and Sn: 0.3 at% and the crystal grains (B) had an average composition of In: 98.2 at% and Sn: 1.8 at%. Thus the difference in the average tin content between the crystal grains (A) and the crystal grains (B) was 0.015 in terms of the atomic ratio represented by Sn/(In+Sn). All crystal grains generally had a particle diameter of more than 1 µm.

The sintered oxide was subsequently subjected to phase identification by X-ray diffractometry and TEM observation. As a result, the obtained sintered oxide included only an In₂O₃ phase of bixbyite-type structure and the presence of an In₉Sn₃O₁₂ indium stannate compound phase was not confirmed.

From the above analysis results, it was concluded, as shown in Tables 1 and 2, that the sintered oxide of the present Example mainly included the crystal grains (A) having a tin content that was less than the average tin content of the sintered oxide and the crystal grains (B) having a tin content that was at or above the average tin content of the sintered oxide and had a density of 3.4 to 5.5 g/cm³, wherein the crystal grains (A) and (B) contained tin in the form of solid solution and corresponded to crystal grains including an In₂O₃ phase of bixbyite-type structure.

The sintered oxide was processed to obtain tablets which were subjected to continuous discharge using a plasma gun by ion plating until the tablets were unusable. The ion plating device used was, as Example 1, a reactive plasma deposition apparatus for high density plasma assist deposition (HDPE) and discharge was carried out as Example 1. In order to examine film formation stability of tablets, specifically 10 tablets were observed until they were unusable for generation of problems such as cracks and breakage or splashing, which did not result in generation of the problematic phenomena.

Film formation was carried out using fresh tablets. A transparent conductive film having a thickness of 200 nm was formed with a 7059 substrate from Corning at a substrate temperature of 300°C. It was found that the resulting transparent conductive film had the composition almost the same as that of the tablets.

The film was measured for the specific resistance which was found to be 2.8 × 10⁻⁴ Ωcm. The film was measured for the transmittance and it was found that the average transmittance of visible light and the transmittance at a wavelength of 1200 nm were both above 85%. The result of analysis of crystallinity of the film by X-ray diffractometry showed that the film was a crystalline film only including an indium oxide phase and that tin in the form of solid solution was mixed with the indium oxide phase.

### (Example 3)

A sintered oxide and then tablets for ion plating were prepared in the same manner as Example 1 except that starting material powders were weighed so as to obtain a tin content of 0.019 in terms of the atomic ratio represented by Sn/(In+Sn) and the proportion of indium oxide powder mixed with the total amount of the tin oxide powder was 50% by weight of the total indium oxide powder.

The obtained sintered oxide was subjected to compositional analysis by ICP optical emission spectrometry and was found to have almost the same composition as the charged composition at the time of weighing of the starting material powders. The sintered oxide was measured for the density which was found to be 4.95 g/cm³.

Next, an In₄Sn₃O₁₂ indium stannate compound phase was not confirmed. The sintered oxide was subjected to the texture analysis by EPMA observation and the compositional analysis of crystal grains in the same manner as Example 1. The result of point analysis of the elemental distribution showed that there were crystal grains (A) having a tin content that was less than the average tin content of the sintered oxide and crystal grains (B) having a tin content that was at or above the average tin content of the sintered oxide. The crystal grains (A) had an average composition of In: 99.4 at% and Sn: 0.6 at% and the crystal grains (B) had an average composition of In: 95.4 at% and Sn: 4.6 at%. Thus the difference in the average tin content between the crystal grains (A) and the crystal grains (B) was 0.04 in terms of the atomic ratio represented by Sn/ (In+Sn). All crystal grains generally had a particle diameter of more than 1 µm.

The sintered oxide was subsequently subjected to phase identification by X-ray diffractometry and TEM observation. As a result, the obtained sintered oxide included only an In₂O₃ phase of bixbyite-type structure and the presence of an In₄Sn₃O₁₂ indium stannate compound phase was not confirmed.

From the above analysis results, it was concluded, as shown in Tables 1 and 2, that the sintered oxide of the present Example mainly included the crystal grains (A) having a tin content that was less than the average tin content of the sintered oxide and the crystal grains (B) having a tin content that was at or above the average tin content of the sintered oxide and had a density of 3.4 to 5.5 g/cm³, wherein the crystal grains (A) and (B) contained tin in the form of solid solution and corresponded to crystal grains including an In₂O₃ phase of bixbyite-type structure.

The sintered oxide was processed to obtain tablets which were subjected to continuous discharge using a plasma gun by ion plating until the tablets were unusable. The ion plating device used was, as Example 1, a reactive plasma deposition apparatus for high density plasma assist deposition (HDPE) and discharge was carried out as Example 1. In order to examine film formation stability of tablets, specifically 10 tablets were observed until they were unusable for generation of problems such as cracks and breakage or splashing, which did not result in generation of the problematic phenomena.

Film formation was carried out using fresh tablets. A transparent conductive film having a thickness of 200 nm was formed with a 7059 substrate from Corning at a substrate temperature of 300°C. It was found that the resulting transparent conductive film had the composition almost the same as that of the tablets.

The film was measured for the specific resistance which was found to be 2.6 × 10⁻⁴ Ωcm. The film was measured for the transmittance and it was found that the average transmittance of visible light and the transmittance at a wavelength of 1200 nm were both above 85%. The result of analysis of crystallinity of the film by X-ray diffractometry showed that the film was a crystalline film only including an indium oxide phase and that tin in the form of solid solution was mixed with the indium oxide phase.

### (Example 4)

A sintered oxide and then tablets for ion plating were prepared in the same manner as Example 1 except that starting material powders were weighed so as to obtain a tin content of 0.031 in terms of the atomic ratio represented by Sn/(In+Sn) and the proportion of indium oxide powder mixed with the total amount of the tin oxide powder was 50% by weight of the total indium oxide powder.

The obtained sintered oxide was subjected to compositional analysis by ICP optical emission spectrometry and was found to have almost the same composition as the charged composition at the time of weighing of the starting material powders. The sintered oxide was measured for the density which was found to be 4.95 g/cm³.

The sintered oxide was then subjected to the texture analysis by EPMA observation and the compositional analysis of crystal grains in the same manner as Example 1. The result of point analysis of the elemental distribution showed that there were crystal grains (A) having a tin content that was less than the average tin content of the sintered oxide and crystal grains (B) having a tin content that was at or above the average tin content of the sintered oxide. The crystal grains (A) had an average composition of In: 99.0 at% and Sn: 1.0 at% and the crystal grains (B) had an average composition of In: 92.6 at% and Sn: 7.4 at%. Thus the difference in the average tin content between the crystal grains (A) and the crystal grains (B) was 0.064 in terms of the atomic ratio represented by Sn/ (In+Sn). All crystal grains generally had a particle diameter of more than 1 µm.

The sintered oxide was subsequently subjected to phase identification by X-ray diffractometry and TEM observation. As a result, the obtained sintered oxide included only an In₂O₃ phase of bixbyite-type structure and the presence of an In₄Sn₃O₁₂ indium stannate compound phase was not confirmed.

From the above analysis results, it was concluded, as shown in Tables 1 and 2, that the sintered oxide of the present Example mainly included the crystal grains (A) having a tin content that was less than the average tin content of the sintered oxide and the crystal grains (B) having a tin content that was at or above the average tin content of the sintered oxide and had a density of 3.4 to 5. 5 g/cm³, wherein the crystal grains (A) and (B) contained tin in the form of solid solution and corresponded to crystal grains including an In₂O₃ phase of bixbyite-type structure.

The sintered oxide was processed to obtain tablets which were subjected to continuous discharge using a plasma gun by ion plating until the tablets were unusable. The ion plating device used was, as Example 1, a reactive plasma deposition apparatus for high density plasma assist deposition (HDPE) and discharge was carried out as Example 1. In order to examine film formation stability of tablets, specifically 10 tablets were observed until they were unusable for generation of problems such as cracks and breakage or splashing, which did not result in generation of the problematic phenomena.

Film formation was carried out using fresh tablets. A transparent conductive film having a thickness of 200 nm was formed with a 7059 substrate from Corning at a substrate temperature of 300°C. It was found that the resulting transparent conductive film had the composition almost the same as that of the tablets.

The film was measured for the specific resistance which was found to be 2.0 × 10⁻⁴ Ωcm. The film was measured for the transmittance and it was found that the average transmittance of visible light and the transmittance at a wavelength of 1200 nm were both above 80%. The result of analysis of crystallinity of the film by X-ray diffractometry showed that the film was a crystalline film only including an indium oxide phase and that tin in the form of solid solution was mixed with the indium oxide phase.

### (Example 5)

A sintered oxide and then tablets for ion plating were prepared in the same manner as Example 1 except that starting material powders were weighed so as to obtain a tin content of 0. 046 in terms of the atomic ratio represented by Sn/(In+Sn) and the proportion of indium oxide powder mixed with the total amount of the tin oxide powder was 20% by weight of the total indium oxide powder.

The obtained sintered oxide was subjected to compositional analysis by ICP optical emission spectrometry and was found to have almost the same composition as the charged composition at the time of weighing of the starting material powders. The sintered oxide was measured for the density which was found to be 5.02 g/cm³.

The sintered oxide was then subjected to the texture analysis by EPMA observation and the compositional analysis of crystal grains in the same manner as Example 1. The result of point analysis of the elemental distribution showed that there were crystal grains (A) having an amount of tin in the form of solid solution that was less than the average tin content of the sintered oxide and crystal grains (B) having an amount of tin in the form of solid solution that was at or above the average tin content of the sintered oxide. The crystal grains (A) had an average composition of In: 98.5 at% and Sn: 1. 5 at% and the crystal grains (B) had an average composition of In: 77.9 at% and Sn: 22.1 at%. Thus the difference in the average tin content between the crystal grains (A) and the crystal grains (B) was 0.206 in terms of the atomic ratio represented by Sn/ (In+Sn) . All crystal grains generally had a particle diameter of more than 1 µm.

The sintered oxide was subsequently subjected to phase identification by X-ray diffractometry and TEM observation. As a result, it was found that the obtained sintered oxide included an In₂O₃ phase of bixbyite-type structure and an In₄Sn₃O₁₂ indium stannate compound phase.

From the above analysis results, it was concluded, as shown in Tables 1 and 2, that the sintered oxide of the present Example mainly included the crystal grains (A) having a tin content that was less than the average tin content of the sintered oxide and the crystal grains (B) having a tin content that was at or above the average tin content of the sintered oxide and had a density of 3.4 to 5.5 g/cm³, wherein the crystal grains (A) and (B) contained tin in the form of solid solution and corresponded to either crystal grains including an In₂O₃ phase of bixbyite-type structure or crystal grains (C) including an indium stannate compound phase.

The sintered oxide was processed to obtain tablets which were subjected to continuous discharge using a plasma gun by ion plating until the tablets were unusable. The ion plating device used was, as Example 1, a reactive plasma deposition apparatus for high density plasma assist deposition (HDPE) and discharge was carried out as Example 1. In order to examine film formation stability of tablets, specifically 10 tablets were observed until they were unusable for generation of problems such as cracks and breakage or splashing, which did not result in generation of the problematic phenomena.

Film formation was carried out using fresh tablets. A transparent conductive film having a thickness of 200 nm was formed with a 7059 substrate from Corning at a substrate temperature of 300°C. It was found that the resulting transparent conductive film had the composition almost the same as that of the tablets.

The film was measured for the specific resistance which was found to be 1.4 × 10⁻⁴ Ωcm. The film was measured for the transmittance and it was found that the average transmittance of visible light was above 85% while the transmittance at a wavelength of 1200 nm was below 80%. The result of analysis of crystallinity of the film by X-ray diffractometry showed that the film was a crystalline film only including an indium oxide phase and that tin in the form of solid solution was mixed with the indium oxide phase.

### (Example 6)

A sintered oxide and then tablets for ion plating were prepared in the same manner as Example 1 except that starting material powders were weighed so as to obtain a tin content of 0.07 in terms of the atomic ratio represented by Sn/(In+Sn) and the proportion of indium oxide powder mixed with the total amount of the tin oxide powder was 50% by weight of the total indium oxide powder.

The obtained sintered oxide was subjected to compositional analysis by ICP optical emission spectrometry and was found to have almost the same composition as the charged composition at the time of weighing of the starting material powders. The sintered oxide was measured for the density which was found to be 4.94 g/cm³.

The sintered oxide was then subjected to the texture analysis by EPMA observation and the compositional analysis of crystal grains in the same manner as Example 1. The result of point analysis of the elemental distribution showed that there were crystal grains (A) having a tin content that was less than the average tin content of the sintered oxide and crystal grains (B) having a tin content that was at or above the average tin content of the sintered oxide. The crystal grains (A) had an average composition of In: 97.7 at% and Sn: 2.3 at% and the crystal grains (B) had an average composition of In: 83.8 at% and Sn: 16.2 at%. Thus the difference in the average tin content between the crystal grains (A) and the crystal grains (B) was 0.139 in terms of the atomic ratio represented by Sn/ (In+Sn) . All crystal grains generally had a particle diameter of more than 1 µm.

The sintered oxide was subsequently subjected to phase identification by X-ray diffractometry and TEM observation. As a result, it was found that the obtained sintered oxide included an In₂O₃ phase of bixbyite-type structure and an In₄Sn₃O₁₂ indium stannate compound phase.

From the above analysis results, it was concluded, as shown in Tables 1 and 2, that the sintered oxide of the present Example mainly included the crystal grains (A) having a tin content that was less than the average tin content of the sintered oxide and the crystal grains (B) having a tin content that was at or above the average tin content of the sintered oxide and had a density of 3.4 to 5. 5 g/cm³, wherein the crystal grains (A) and (B) contained tin in the form of solid solution and corresponded to either crystal grains including an In₂O₃ phase of bixbyite-type structure or crystal grains (C) including an indium stannate compound phase.

The sintered oxide was processed to obtain tablets which were subjected to continuous discharge using a plasma gun by ion plating until the tablets were unusable. The ion plating device used was, as Example 1, a reactive plasma deposition apparatus for high density plasma assist deposition (HDPE) and discharge was carried out as Example 1. In order to examine film formation stability of tablets, specifically 10 tablets were observed until they were unusable for generation of problems such as cracks and breakage or splashing, which did not result in generation of the problematic phenomena.

Film formation was carried out using fresh tablets. A transparent conductive film having a thickness of 200 nm was formed with a 7059 substrate from Corning at a substrate temperature of 300°C. It was found that the resulting transparent conductive film had the composition almost the same as that of the tablets.

The film was measured for the specific resistance which was found to be 1.9 × 10⁻⁴ Ωcm. The film was measured for the transmittance and it was found that the average transmittance of visible light was above 85% while the transmittance at a wavelength of 1200 nm was below 80%. The result of analysis of crystallinity of the film by X-ray diffractometry showed that the film was a crystalline film only including an indium oxide phase and that tin in the form of solid solution was mixed with the indium oxide phase.

### (Example 7)

A sintered oxide and then tablets for ion plating were prepared in the same manner as Example 1 except that starting material powders were weighed so as to obtain a tin content of 0.14 in terms of the atomic ratio represented by Sn/(In+Sn) and the proportion of indium oxide powder mixed with the total amount of the tin oxide powder was 50% by weight of the total indium oxide powder.

The obtained sintered oxide was subjected to compositional analysis by ICP optical emission spectrometry and was found to have almost the same composition as the charged composition at the time of weighing of the starting material powders. The sintered oxide was measured for the density which was found to be 4.85 g/cm³.

The sintered oxide was then subjected to the texture analysis by EPMA observation and the compositional analysis of crystal grains in the same manner as Example 1. The result of point analysis of the elemental distribution showed that there were crystal grains having an amount of tin in the form of solid solution that was less than the average tin content of the sintered oxide and crystal grains having an amount of tin in the form of solid solution that was at or above the average tin content of the sintered oxide. The crystal grains (A) had an average composition of In: 95.5 at% and Sn: 4.5 at% and the crystal grains (B) had an average composition of In: 69.4 at% and Sn: 30.6 at%. Thus the difference in the average tin content between the crystal grains (A) and the crystal grains (B) was 0.261 in terms of the atomic ratio represented by Sn/(In+Sn). All crystal grains generally had a particle diameter of more than 1 µm.

The sintered oxide was subsequently subjected to phase identification by X-ray diffractometry and TEM observation. It was found that the obtained sintered oxide included an In₂O₃ phase of bixbyite-type structure and an In₄Sn₃O₁₂ indium stannate compound phase.

From the above analysis results, it was concluded, as shown in Tables 1 and 2, that the sintered oxide of the present Example mainly included the crystal grains (A) having a tin content that was less than the average tin content of the sintered oxide and the crystal grains (B) having a tin content that was at or above the average tin content of the sintered oxide and had a density of 3.4 to 5.5 g/cm³, wherein the crystal grains (A) and (B) contained tin in the form of solid solution and corresponded to either crystal grains including an In₂O₃ phase of bixbyite-type structure or crystal grains (C) including an indium stannate compound phase.

The sintered oxide was processed to obtain tablets which were subjected to continuous discharge using a plasma gun by ion plating until the tablets were unusable. The ion plating device used was, as Example 1, a reactive plasma deposition apparatus for high density plasma assist deposition (HDPE) and discharge was carried out as Example 1. In order to examine film formation stability of tablets, specifically 10 tablets were observed until they were unusable for generation of problems such as cracks and breakage or splashing, which did not result in generation of the problematic phenomena.

Film formation was carried out using fresh tablets. A transparent conductive film having a thickness of 200 nm was formed with a 7059 substrate from Corning at a substrate temperature of 300°C. It was found that the resulting transparent conductive film had the composition almost the same as that of the tablets.

The film was measured for the specific resistance which was found to be 3.5 × 10⁻⁴ Ωcm. The film was measured for the transmittance and it was found that the average transmittance of visible light was above 85% while the transmittance at a wavelength of 1200 nm was below 80%. The result of analysis of crystallinity of the film by X-ray diffractometry showed that the film was a crystalline film only including an indium oxide phase and that tin in the form of solid solution was mixed with the indium oxide phase.

### (Example 8)

Starting material powders were indium oxide powder and tin oxide powder both of which had an average particle diameter of 1.5 µm or less. Both powders were weighed so as to obtain a tin content of 0.037 in terms of the atomic ratio of Sn/(In+Sn). Among these, 75% by weight of indium oxide powder and the total amount of tin oxide powder were placed in a resin pot together with water, a dispersing agent and the like and mixed in a wet ball mill. Hard ZrO₂ balls were used for mixing of 18 hours. After mixing, slurry was removed, filtered and dried to obtain primary mixed powder. The primary mixed powder was then calcinated in a sintering furnace with a heating rate of 1°C/min under the conditions of 1250°C and 10 hours. The residual indium oxide powder was not calcinated. The calcinated powder and the non-calcinated powder were then again mixed in a wet ball mill. After mixing, slurry was filtered and dried to obtain secondary mixed powder. The secondary mixed powder was then granulated. The granulated powder was then charged in a mold and molded on a uniaxial press while applying pressure of 9.8 MPa so as to have the shape of tablets. The tablet was molded so as to have the dimensions after sintering of 30 mm in diameter and 40 mm in height.

The molded articles were then sintered as follows. The molded articles were sintered in an atmosphere wherein oxygen was introduced to air in the sintering furnace at a rate of 5 liter/min per 0.1 m3 of the sintering furnace volume and at a sintering temperature of 1250°C for 20 hours. The heating rate was 1°C/min and introduction of oxygen was terminated upon cooling after sintering to 1000°C at a cooling rate of 10°C/min.

The obtained sintered oxide was subjected to compositional analysis by ICP optical emission spectrometry and found to have almost the same composition as the charged composition at the time of weighing of the starting material powders. Namely, the average tin content of the sintered oxide is almost the same as the charged composition at the time of weighing of the starting material powders. The sintered oxide was measured for the density which was found to be 4.87 g/cm³.

The sintered oxide was then subjected to the texture analysis by EPMA observation and the compositional analysis of crystal grains. The result of point analysis of the elemental distribution showed that there were crystal grains (A) having a tin content that was less than the average tin content of the sintered oxide and crystal grains (B) having a tin content that was at or above the average tin content of the sintered oxide. The crystal grains (A) had an average composition of In: 98.8 at % and Sn: 1.2 at% and the crystal grains (B) had an average composition of In: 93.6 at% and Sn: 6.4 at %. Thus the difference in the average tin content between the crystal grains (A) and the crystal grains (B) was 0.052 in terms of the atomic ratio represented by Sn/(In+Sn). All crystal grains generally had a particle diameter of more than 1 µm.

The sintered oxide was subsequently subjected to phase identification by X-ray diffractometry and TEM observation. The obtained sintered oxide included only an In₂O₃ phase of bixbyite-type structure and the presence of an In₄Sn₃O₁₂ indium stannate compound phase was not confirmed.

From the above analysis results, it was concluded, as shown in Tables 1 and 2, that the sintered oxide of the present Example mainly included the crystal grains (A) having a tin content that was less than the average tin content of the sintered oxide and the crystal grains (B) having a tin content that was at or above the average tin content of the sintered oxide and had a density of 3.4 to 5.5 g/cm³, wherein the crystal grains (A) and (B) contained tin in the form of solid solution and corresponded to crystal grains including an In₂O₃ phase of bixbyite-type structure.

The sintered oxide was processed to obtain tablets which were subjected to continuous discharge using a plasma gun by ion plating until the tablets were unusable. The ion plating device used was, as Example 1, a reactive plasma deposition apparatus for high density plasma assist deposition (HDPE) and discharge was carried out as Example 1. In order to examine film formation stability of tablets, specifically 10 tablets were observed until they were unusable for generation of problems such as cracks and breakage or splashing, which did not result in generation of the problematic phenomena.

Film formation was carried out using fresh tablets. A transparent conductive film having a thickness of 200 nm was formed with a 7059 substrate from Corning at a substrate temperature of 300°C. It was found that the resulting transparent conductive film had the composition almost the same as that of the tablets.

The film was measured for the specific resistance which was found to be 1.9 × 10⁻⁴ Ωcm. The film was measured for the transmittance and it was found that the average transmittance of visible light was above 85% while the transmittance at a wavelength of 1200 nm was below 80%. The result of analysis of crystallinity of the film by X-ray diffractometry showed that the film was a crystalline film only including an indium oxide phase and that tin in the form of solid solution was mixed with the indium oxide phase.

### (Example 9)

Starting material powders were indium oxide powder, tin oxide powder and titanium oxide powder all of which had an average particle diameter of 1. 5 µm or less. All powders were weighed so as to obtain a tin content of 0.008 in terms of the atomic ratio of Sn/ (In+Sn+Ti) and a titanium content of 0.008 in terms of the atomic ratio of Ti/(In+Sn+Ti). Among these, 50% by weight of indium oxide powder and the total amount of tin oxide powder and titanium oxide were placed in a resin pot together with water, a dispersing agent and the like and mixed in a wet ball mill. Hard ZrO₂ balls were used for mixing of 18 hours. After mixing, slurry was removed, filtered and dried to obtain primary mixed powder. The primary mixed powder was then calcinated in a sintering furnace with a heating rate of 1°C/min under the conditions of 1250°C and 10 hours. The residual indium oxide powder was not calcinated. The calcinated powder and the non-calcinated powder were then again mixed in a wet ball mill. After mixing, slurry was filtered and dried to obtain secondary mixed powder. The secondary mixed powder was then granulated. The granulated powder was then charged in a mold and molded on a uniaxial press while applying pressure of 9.8 MPa so as to have the shape of tablets. The tablet was molded so as to have the dimensions after sintering of 30 mm in diameter and 40 mm in height.

The molded articles were then sintered as follows. The molded articles were sintered in an atmosphere wherein oxygen was introduced to air in the sintering furnace at a rate of 5 liter/min per 0.1 m³ of the sintering furnace volume and at a sintering temperature of 1250°C for 20 hours. The heating rate was 1°C/min and introduction of oxygen was terminated upon cooling after sintering to 1000°C at a cooling rate of 10°C/min.

The obtained sintered oxide was subjected to compositional analysis by ICP optical emission spectrometry and found to have almost the same composition as the charged composition at the time of weighing of the starting material powders. The sintered oxide was measured for the density which was found to be 5.02 g/cm³.

The sintered oxide was then subjected to the texture analysis by EPMA observation and the compositional analysis of crystal grains. The result of point analysis of the elemental distribution showed that there were crystal grains (A) having at least a tin content that was less than the average tin content of the sintered oxide and crystal grains (B) having at least a tin content that was at or above the average tin content of the sintered oxide. It was also found that titanium coexisted in the crystal grains containing tin. The crystal grains (A) had an average composition of In: 99.4 at%, Sn: 0.3 at% and Ti: 0.3 at% and the crystal grains (B) had an average composition of In: 94.1 at%, Sn: 3.0 at% and Ti : 2.9 at%. Thus the difference in the average tin content between the crystal grains (A) and the crystal grains (B) was 0.027 in terms of the atomic ratio represented by Sn/(In+Sn+Ti). All crystal grains generally had a particle diameter of more than 1 µm.

The sintered oxide was subsequently subjected to phase identification by X-ray diffractometry and TEM observation. The obtained sintered oxide included only an In₂O₃ phase of bixbyite-type structure and the presence of an In₄Sn₃O₁₂ indium stannate compound phase was not confirmed.

From the above analysis results, it was concluded, as shown in Tables 1 and 2, that the sintered oxide of the present Example mainly included the crystal grains (A) having at least a tin content that was less than the average tin content of the sintered oxide and the crystal grains (B) having at least a tin content that was at or above the average tin content of the sintered oxide and had a density of 3.4 to 5.5 g/cm³, wherein the crystal grains (A) and (B) contained tin in the form of solid solution and corresponded to crystal grains including an In₂O₃ phase of bixbyite-type structure.

The sintered oxide was processed to obtain tablets which were subjected to continuous discharge using a plasma gun by ion plating until the tablets were unusable. The ion plating device used was, as Example 1, a reactive plasma deposition apparatus for high density plasma assist deposition (HDPE) and discharge was carried out as Example 1. In order to examine film formation stability of tablets, specifically 10 tablets were observed until they were unusable for generation of problems such as cracks and breakage or splashing, which did not result in generation of the problematic phenomena.

Film formation was carried out using fresh tablets. A transparent conductive film having a thickness of 200 nm was formed with a 7059 substrate from Corning at a substrate temperature of 300°C. It was found that the resulting transparent conductive film had the composition almost the same as that of the tablets.

The film was measured for the specific resistance which was found to be 2.1 × 10⁻⁴ Ωcm. The film was measured for the transmittance and it was found that the average transmittance of visible light and the transmittance at a wavelength of 1200 nm were both above 85%. The result of analysis of crystallinity of the film by X-ray diffractometry showed that the film was a crystalline film only including an indium oxide phase and that tin and titanium in the form of solid solution were mixed with the indium oxide phase.

### (Example 10)

Starting material powders were indium oxide powder, tin oxide powder and zirconium oxide powder all of which had an average particle diameter of 1.5 µm or less. All powders were weighed so as to obtain a tin content of 0.008 in terms of the atomic ratio of Sn/(In+Sn+Zr) and a zirconium content of 0.008 in terms of the atomic ratio of Zr/ (In+Sn+Zr). Among these, 50% by weight of indium oxide powder and the total amount of tin oxide powder and zirconium oxide were placed in a resin pot together with water, a dispersing agent and the like and mixed in a wet ball mill. Hard ZrO₂ balls were used for mixing of 18 hours. After mixing, slurry was removed, filtered and dried to obtain primary mixed powder. The primary mixed powder was then calcinated in a sintering furnace with a heating rate of 1°C/min under the conditions of 1250°C and 10 hours. The residual indium oxide powder was not calcinated. The calcinated powder and the non-calcinated powder were then again mixed in a wet ball mill. After mixing, slurry was filtered and dried to obtain secondary mixed powder. The secondary mixed powder was then granulated. The granulated powder was then charged in a mold and molded on a uniaxial press while applying pressure of 9.8 MPa so as to have the shape of tablets. The tablet was molded so as to have the dimensions after sintering of 30 mm in diameter and 40 mm in height.

The molded articles were then sintered as follows. The molded articles were sintered in an atmosphere wherein oxygen was introduced to air in the sintering furnace at a rate of 5 liter/min per 0.1 m³ of the sintering furnace volume and at a sintering temperature of 1250°C for 20 hours. The heating rate was 1°C/min and introduction of oxygen was terminated upon cooling after sintering to 1000°C at a cooling rate of 10°C/min.

The obtained sintered oxide was subjected to compositional analysis by ICP optical emission spectrometry and found to have almost the same composition as the charged composition at the time of weighing of the starting material powders. The sintered oxide was measured for the density which was found to be 4.81 g/cm³.

The obtained sintered oxide was then subjected to phase identification by X-ray diffractometry. It was found that the sintered oxide included only an In₂O₃ phase of bixbyite-type structure. An In₄Sn₃O₁₂ indium stannate compound phase was not confirmed. The sintered oxide was subjected to the texture analysis by EPMA observation and the compositional analysis of crystal grains. The result of point analysis of the elemental distribution showed that there were crystal grains (A) having at least a tin content that was less than the average tin content of the sintered oxide and crystal grains (B) having at least an amount of tin in the form of solid solution that was at or above the average tin content of the sintered oxide. It was also found that zirconium coexisted in the crystal grains containing tin. The crystal grains (A) had an average composition of In: 99.5 at%, Sn: 0.3 at% and Zr: 0.2 at% and the crystal grains (B) had an average composition of In: 94.0 at%, Sn: 2.9 at% and Zr: 3.1 at%. Thus the difference in the average tin content between the crystal grains (A) and the crystal grains (B) was 0.026 in terms of the atomic ratio represented by Sn/(In+Sn+Zr). All crystal grains generally had a particle diameter of more than 1 µm.

The sintered oxide was subsequently subjected to phase identification by X-ray diffractometry and TEM observation. The obtained sintered oxide included only an In₂O₃ phase of bixbyite-type structure and the presence of an In₄Sn₃O₁₂ indium stannate compound phase was not confirmed.

From the above analysis results, it was concluded, as shown in Tables 1 and 2, that the sintered oxide of the present Example mainly included the crystal grains (A) having at least a tin content that was less than the average tin content of the sintered oxide and the crystal grains (B) having at least a tin content that was at or above the average tin content of the sintered oxide and had a density of 3.4 to 5.5 g/cm³, wherein the crystal grains (A) and (B) contained tin in the form of solid solution and corresponded to crystal grains including an In₂O₃ phase of bixbyite-type structure.

The sintered oxide was processed to obtain tablets which were subjected to continuous discharge using a plasma gun by ion plating until the tablets were unusable. The ion plating device used was, as Example 1, a reactive plasma deposition apparatus for high density plasma assist deposition (HDPE) and discharge was carried out as Example 1. In order to examine film formation stability of tablets, specifically 10 tablets were observed until they were unusable for generation of problems such as cracks and breakage or splashing, which did not result in generation of the problematic phenomena.

Film formation was carried out using fresh tablets. A transparent conductive film having a thickness of 200 nm was formed with a 7059 substrate from Corning at a substrate temperature of 300°C. It was found that the resulting transparent conductive film had the composition almost the same as that of the tablets.

The film was measured for the specific resistance which was found to be 2.5 × 10⁻⁴ Ωcm. The film was measured for the transmittance and it was found that the average transmittance of visible light and the transmittance at a wavelength of 1200 nm were both above 85%. The result of analysis of crystallinity of the film by X-ray diffractometry showed that the film was a crystalline film only including an indium oxide phase and that tin and zirconium in the form of solid solution were mixed with the indium oxide phase.

### (Example 11)

Starting material powders were indium oxide powder, tin oxide powder and hafnium oxide powder all of which had an average particle diameter of 1.5 µm or less. All powders were weighed so as to obtain a tin content of 0.008 in terms of the atomic ratio of Sn/ (In+Sn+Hf) and a hafnium content of 0.008 in terms of the atomic ratio of Hf/(In+Sn+Hf). Among these, 50% by weight of indium oxide powder and the total amount of tin oxide powder and hafnium oxide were placed in a resin pot together with water, a dispersing agent and the like and mixed in a wet ball mill. Hard ZrO₂ balls were used for mixing of 18 hours. After mixing, slurry was removed, filtered and dried to obtain primary mixed powder. The primary mixed powder was then calcinated in a sintering furnace with a heating rate of 1°C/min under the conditions of 1250°C and 10 hours. The residual indium oxide powder was not calcinated. The calcinated powder and the non-calcinated powder were then again mixed in a wet ball mill. After mixing, slurry was filtered and dried to obtain secondary mixed powder. The secondary mixed powder was then granulated. The granulated powder was then charged in a mold and molded on a uniaxial press while applying pressure of 9.8 MPa so as to have the shape of tablets. The tablet was molded so as to have the dimensions after sintering of 30 mm in diameter and 40 mm in height.

The molded articles were then sintered as follows. The molded articles were sintered in an atmosphere wherein oxygen was introduced to air in the sintering furnace at a rate of 5 liter/min per 0.1 m³ of the sintering furnace volume and at a sintering temperature of 1250°C for 20 hours. The heating rate was 1°C/min and introduction of oxygen was terminated upon cooling after sintering to 1000°C at a cooling rate of 10°C/min.

The obtained sintered oxide was subjected to compositional analysis by ICP optical emission spectrometry and found to have almost the same composition as the charged composition at the time of weighing of the starting material powders. The sintered oxide was measured for the density which was found to be 4.95 g/cm³.

The sintered oxide was then subjected to the texture analysis by EPMA observation and the compositional analysis of crystal grains. The result of point analysis of the elemental distribution showed that there were crystal grains (A) having at least a tin content that was less than the average tin content of the sintered oxide and crystal grains (B) having at least a tin content that was at or above the average tin content of the sintered oxide. It was also found that hafnium coexisted in the crystal grains containing tin. The crystal grains (A) had an average composition of In: 99.4 at%, Sn: 0.4 at% and Hf: 0.2 at% and the crystal grains (B) had an average composition of In: 93.9 at%, Sn: 3.1 at% and Hf: 3.0 at%. Thus the difference in the average tin content between the crystal grains (A) and the crystal grains (B) was 0.027 in terms of the atomic ratio represented by Sn/(In+Sn+Hf). All crystal grains generally had a particle diameter of more than 1 µm.

The sintered oxide was subsequently subjected to phase identification by X-ray diffractometry and TEM observation. The obtained sintered oxide included only an In₂O₃ phase of bixbyite-type structure and the presence of an In₄Sn₃O₁₂ indium stannate compound phase was not confirmed.

From the above analysis results, it was concluded, as shown in Tables 1 and 2, that the sintered oxide of the present Example mainly included the crystal grains (A) having at least a tin content that was less than the average tin content of the sintered oxide and the crystal grains (B) having at least a tin content that was at or above the average tin content of the sintered oxide and had a density of 3.4 to 5.5 g/cm³, wherein the crystal grains (A) and (B) contained tin in the form of solid solution and corresponded to crystal grains including an In₂O₃ phase of bixbyite-type structure.

The sintered oxide was processed to obtain tablets which were subjected to continuous discharge using a plasma gun by ion plating until the tablets were unusable. The ion plating device used was, as Example 1, a reactive plasma deposition apparatus for high density plasma assist deposition (HDPE) and discharge was carried out as Example 1. In order to examine film formation stability of tablets, specifically 10 tablets were observed until they were unusable for generation of problems such as cracks and breakage or splashing, which did not result in generation of the problematic phenomena.

Film formation was carried out using fresh tablets. A transparent conductive film having a thickness of 200 nm was formed with a 7059 substrate from Corning at a substrate temperature of 300°C. It was found that the resulting transparent conductive film had the composition almost the same as that of the tablets.

The film was measured for the specific resistance which was found to be 2.4 × 10⁻⁴ Ωcm. The film was measured for the transmittance and it was found that the average transmittance of visible light and the transmittance at a wavelength of 1200 nm were both above 85%. The result of analysis of crystallinity of the film by X-ray diffractometry showed that the film was a crystalline film only including an indium oxide phase and that tin and hafnium in the form of solid solution were mixed with the indium oxide phase.

### (Example 12)

Starting material powders were indium oxide powder, tin oxide powder and tungsten oxide powder all of which had an average particle diameter of 1. 5 µm or less. All powders were weighed so as to obtain a tin content of 0.008 in terms of the atomic ratio of Sn/(In+Sn+W) and a tungsten content of 0.008 in terms of the atomic ratio of W/ (In+Sn+W). Among these, 50% by weight of indium oxide powder and the total amount of tin oxide powder and tungsten oxide were placed in a resin pot together with water, a dispersing agent and the like and mixed in a wet ball mill. Hard ZrO₂ balls were used for mixing of 18 hours. After mixing, slurry was removed, filtered and dried to obtain primary mixed powder. The primary mixed powder was then calcinated in a sintering furnace with a heating rate of 1°C/min under the conditions of 1250°C and 10 hours. The residual indium oxide powder was not calcinated. The calcinated powder and the non-calcinated powder were then again mixed in a wet ball mill. After mixing, slurry was filtered and dried to obtain secondary mixed powder. The secondary mixed powder was then granulated. The granulated powder was then charged in a mold and molded on a uniaxial press while applying pressure of 9.8 MPa so as to have the shape of tablets. The tablet was molded so as to have the dimensions after sintering of 30 mm in diameter and 40 mm in height.

The molded articles were then sintered as follows. The molded articles were sintered in an atmosphere wherein oxygen was introduced to air in the sintering furnace at a rate of 5 liter/min per 0.1 m³ of the sintering furnace volume and at a sintering temperature of 1250°C for 20 hours. The heating rate was 1°C/min and introduction of oxygen was terminated upon cooling after sintering to 1000°C at a cooling rate of 10°C/min.

The obtained sintered oxide was subjected to compositional analysis by ICP optical emission spectrometry and found to have almost the same composition as the charged composition at the time of weighing of the starting material powders. The sintered oxide was measured for the density which was found to be 4.67 g/cm³.

The sintered oxide was then subjected to the texture analysis by EPMA observation and the compositional analysis of crystal grains. The result of point analysis of the elemental distribution showed that there were crystal grains (A) having a tin content that was less than the average tin content of the sintered oxide and crystal grains (B) having a tin content that was at or above the average tin content of the sintered oxide. It was also found that tungsten coexisted in the crystal grains containing tin. The crystal grains (A) had an average composition of In: 99.6 at%, Sn: 0.3 at% and W: 0.1 at% and the crystal grains (B) had an average composition of In: 93.6 at%, Sn: 3.1 at% and W: 3.4 at%. Thus the difference in the average tin content between the crystal grains (A) and the crystal grains (B) was 0.028 in terms of the atomic ratio represented by Sn/(In+Sn+W). All crystal grains generally had a particle diameter of more than 1 µm. All crystal grains generally had a particle diameter of more than 1 µm.

The sintered oxide was subsequently subjected to phase identification by X-ray diffractometry and TEM observation. The obtained sintered oxide included only an In₂O₃ phase of bixbyite-type structure and the presence of an In₄Sn₃O₁₂ indium stannate compound phase was not confirmed.

From the above analysis results, it was concluded, as shown in Tables 1 and 2, that the sintered oxide of the present Example mainly included the crystal grains (A) having at least a tin content that was less than the average tin content of the sintered oxide and the crystal grains (B) having at least a tin content that was at or above the average tin content of the sintered oxide and had a density of 3.4 to 5.5 g/cm³, wherein the crystal grains (A) and (B) contained tin in the form of solid solution and corresponded to crystal grains including an In₂O₃ phase of bixbyite-type structure.

The sintered oxide was processed to obtain tablets which were subjected to continuous discharge using a plasma gun by ion plating until the tablets were unusable. The ion plating device used was, as Example 1, a reactive plasma deposition apparatus for high density plasma assist deposition (HDPE) and discharge was carried out as Example 1. In order to examine film formation stability of tablets, specifically 10 tablets were observed until they were unusable for generation of problems such as cracks and breakage or splashing, which did not result in generation of the problematic phenomena.

Film formation was carried out using fresh tablets. A transparent conductive film having a thickness of 200 nm was formed with a 7059 substrate from Corning at a substrate temperature of 300°C. It was found that the resulting transparent conductive film had the composition almost the same as that of the tablets.

The film was measured for the specific resistance which was found to be 2.1 × 10⁻⁴ Ωcm. The film was measured for the transmittance and it was found that the average transmittance of visible light and the transmittance at a wavelength of 1200 nm were both above 85%. The result of analysis of crystallinity of the film by X-ray diffractometry showed that the film was a crystalline film only including an indium oxide phase and that tin and tungsten in the form of solid solution were mixed with the indium oxide phase.

### (Example 13)

Starting material powders were indium oxide powder, tin oxide powder, titanium oxide powder and molybdenum oxide powder all of which had an average particle diameter of 1.5 µm or less. All powders were weighed so as to obtain a tin content of 0.006 in terms of the atomic ratio of Sn/ (In+Sn+Ti+Mo), a titanium content of 0.006 in terms of the atomic ratio of Ti/(In+Sn+Ti+Mo) and a molybdenum content of 0.006 in terms of the atomic ratio of Mo/(In±Sn+Ti+Mo). Among these, 50% by weight of indium oxide powder and the total amount of tin oxide powder and titanium oxide were placed in a resin pot together with water, a dispersing agent and the like and mixed in a wet ball mill. Hard ZrO₂ balls were used for mixing of 18 hours. After mixing, slurry was removed, filtered and dried to obtain primary mixed powder. The primary mixed powder was then calcinated in a sintering furnace with a heating rate of 1°C/min under the conditions of 1250°C and 10 hours. The residual indium oxide powder and the molybdenum oxide powder were not calcinated. The calcinated powder and the non-calcinated powders were again mixed in a wet ball mill. After mixing, slurry was filtered and dried to obtain secondary mixed powder. The secondary mixed powder was then granulated. The granulated powder was then charged in a mold and molded on a uniaxial press while applying pressure of 9.8 MPa so as to have the shape of tablets. The tablet was molded so as to have the dimensions after sintering of 30 mm in diameter and 40 mm in height.

The molded articles were then sintered as follows. The molded articles were sintered in an atmosphere wherein oxygen was introduced to air in the sintering furnace at a rate of 5 liter/min per 0.1 m³ of the sintering furnace volume and at a sintering temperature of 1250°C for 20 hours. The heating rate was 1°C/min and introduction of oxygen was terminated upon cooling after sintering to 1000°C at a cooling rate of 10°C/min.

The obtained sintered oxide was subjected to compositional analysis by ICP optical emission spectrometry and found to have almost the same composition as the charged composition at the time of weighing of the starting material powders. The sintered oxide was measured for the density which was found to be 4.74 g/cm3.

The sintered oxide was then subjected to the texture analysis by EPMA observation and the compositional analysis of crystal grains. The result of point analysis of the elemental distribution showed that there were crystal grains (A) having a tin content that was less than the average tin content of the sintered oxide and crystal grains (B) having a tin content that was at or above the average tin content of the sintered oxide. It was also found that titanium and molybdenum existed with tin. The crystal grains (A) had an average composition of In: 98.4 at%, Sn: 0.2 at%, Ti: 1.4 at% and Mo: 0.3% and the crystal grains (B) had an average composition of In: 95.9 at%, Sn: 2.3 at%, Ti: 0.2% and Mo: 1.8%. Thus the difference in the average tin content between the crystal grains (A) and the crystal grains (B) was 0.021 in terms of the atomic ratio represented by Sn/(In+Sn+Ti+Mo). All crystal grains generally had a particle diameter of more than 1 µm. All crystal grains generally had a particle diameter of more than 1 µm.

The sintered oxide was subsequently subjected to phase identification by X-ray diffractometry and TEM observation. The obtained sintered oxide included only an In₂O₃ phase of bixbyite-type structure and the presence of an In₄Sn₃O₁₂ indium stannate compound phase was not confirmed.

From the above analysis results, it was concluded, as shown in Tables 1 and 2, that the sintered oxide of the present Example mainly included the crystal grains (A) having at least a tin content that was less than the average tin content of the sintered oxide and the crystal grains (B) having at least a tin content that was at or above the average tin content of the sintered oxide and had a density of 3.4 to 5.5 g/cm³, wherein the crystal grains (A) and (B) contained tin in the form of solid solution and corresponded to crystal grains including an In₂O₃ phase of bixbyite-type structure.

The sintered oxide was processed to obtain tablets which were subjected to continuous discharge using a plasma gun by ion plating until the tablets were unusable. The ion plating device used was, as Example 1, a reactive plasma deposition apparatus for high density plasma assist deposition (HDPE) and discharge was carried out as Example 1. In order to examine film formation stability of tablets, specifically 10 tablets were observed until they were unusable for generation of problems such as cracks and breakage or splashing, which did not result in generation of the problematic phenomena.

Film formation was carried out using fresh tablets. A transparent conductive film having a thickness of 200 nm was formed with a 7059 substrate from Corning at a substrate temperature of 300°C. It was found that the resulting transparent conductive film had the composition almost the same as that of the tablets.

The film was measured for the specific resistance which was found to be 2.4 × 10⁻⁴ Ωcm. The film was measured for the transmittance and it was found that the average transmittance of visible light and the transmittance at a wavelength of 1200 nm were both above 85%. The result of analysis of crystallinity of the film by X-ray diffractometry showed that the film was a crystalline film only including an indium oxide phase and that tin, titanium and molybdenum in the form of solid solution were mixed with the indium oxide phase.

### (Example 14)

Starting material powders were indium oxide powder and tin oxide powder both of which had an average particle diameter of 1.5 µm or less. Both powders were weighed so as to obtain a tin content of 0.008 in terms of the atomic ratio of Sn/(In+Sn). Among these, 60% by weight of indium oxide powder and the total amount of tin oxide powder were placed in a resin pot together with water, a dispersing agent and the like and mixed in a wet ball mill. Hard ZrO₂ balls were used for mixing of 18 hours. After mixing, slurry was removed, filtered and dried to obtain primary mixed powder. The primary mixed powder was then calcinated in a sintering furnace with a heating rate of 1°C/min under the conditions of 1000°C and 10 hours. The residual indium oxide powder was not calcinated. The calcinated powder and the non-calcinated powder were then again mixed in a wet ball mill. After mixing, slurry was filtered and dried to obtain secondary mixed powder. The secondary mixed powder was then granulated. The granulated powder was then charged in a mold and molded on a uniaxial press while applying pressure of 4. 9 MPa so as to have the shape of tablets. The tablet was molded so as to have the dimensions after sintering of 30 mm in diameter and 40 mm in height.

The molded articles were then sintered as follows. The molded articles were sintered in an atmosphere wherein oxygen was introduced to air in the sintering furnace at a rate of 5 liter/min per 0.1 m³ of the sintering furnace volume and at a sintering temperature of 1000°C for 20 hours. The heating rate was 1°C/min and introduction of oxygen was terminated upon cooling after sintering to 1000°C at a cooling rate of 10°C/min.

The obtained sintered oxide was subjected to compositional analysis by ICP optical emission spectrometry and found to have almost the same composition as the charged composition at the time of weighing of the starting material powders. The sintered oxide was measured for the density which was found to be 3.44 g/cm³.

The sintered oxide was then subjected to the texture analysis by EPMA observation and the compositional analysis of crystal grains. The result of point analysis of the elemental distribution showed that there were crystal grains (A) having a tin content that was less than the average tin content of the sintered oxide and crystal grains (B) having a tin content that was at or above the average tin content of the sintered oxide. The crystal grains (A) had an average composition of In: 99.8 t% and Sn: 0.2 at% and the crystal grains (B) had an average composition of In: 98.2 at% and Sn: 1.8 at%. Thus the difference in the average tin content between the crystal grains (A) and the crystal grains (B) was 0.016 in terms of the atomic ratio represented by Sn/(In+Sn). All crystal grains generally had a particle diameter of more than 1 µm.

The sintered oxide was subsequently subjected to phase identification by X-ray diffractometry and TEM observation. The obtained sintered oxide included only an In₂O₃ phase of bixbyite-type structure and the presence of an In₄Sn₃O₁₂ indium stannate compound phase was not confirmed.

From the above analysis results, it was concluded, as shown in Tables 1 and 2, that the sintered oxide of the present Example mainly included the crystal grains (A) having a tin content that was less than the average tin content of the sintered oxide and the crystal grains (B) having a tin content that was at or above the average tin content of the sintered oxide and had a density of 3.4 to 5. 5 g/cm³, wherein the crystal grains (A) and (B) contained tin in the form of solid solution and corresponded to crystal grains including an In₂O₃ phase of bixbyite-type structure.

The sintered oxide was processed to obtain tablets which were subjected to continuous discharge using a plasma gun by ion plating until the tablets were unusable. The ion plating device used was, as Example 1, a reactive plasma deposition apparatus for high density plasma assist deposition (HDPE) and discharge was carried out as Example 1. In order to examine film formation stability of tablets, specifically 10 tablets were observed until they were unusable for generation of problems such as cracks and breakage or splashing, which did not result in generation of the problematic phenomena.

Film formation was carried out using fresh tablets. A transparent conductive film having a thickness of 200 nm was formed with a 7059 substrate from Corning at a substrate temperature of 300°C. It was found that the resulting transparent conductive film had the composition almost the same as that of the tablets.

The film was measured for the specific resistance which was found to be 2.2 × 10⁻⁴ Ωcm. The film was measured for the transmittance and it was found that the average transmittance of visible light and the transmittance at a wavelength of 1200 nm were both above 85%. The result of analysis of crystallinity of the film by X-ray diffractometry showed that the film was a crystalline film only including an indium oxide phase and that tin in the form of solid solution was mixed with the indium oxide phase.

### (Example 15)

Starting material powders were indium oxide powder and tin oxide powder both of which had an average particle diameter of 1.5 µm or less. Both powders were weighed so as to obtain a tin content of 0.008 in terms of the atomic ratio of Sn/(In+Sn). Among these, 20% by weight of indium oxide powder and the total amount of tin oxide powder were placed in a resin pot together with water, a dispersing agent and the like and mixed in a wet ball mill. Hard ZrO₂ balls were used for mixing of 18 hours. After mixing, slurry was removed, filtered and dried to obtain primary mixed powder. The primary mixed powder was then calcinated in a sintering furnace with a heating rate of 1°C/min under the conditions of 1450°C and 10 hours. The residual indium oxide powder was not calcinated. The calcinated powder and the nbn-calcinated powder were then again mixed in a wet ball mill. After mixing, slurry was filtered and dried to obtain secondary mixed powder. The secondary mixed powder was then granulated. The granulated powder was then charged in a mold and molded on a uniaxial press while applying pressure of 4.9 MPa so as to have the shape of tablets. The tablet was molded so as to have the dimensions after sintering of 30 mm in diameter and 40 mm in height.

The molded articles were then sintered as follows. The molded articles were sintered in an atmosphere wherein oxygen was introduced to air in the sintering furnace at a rate of 5 liter/min per 0.1 m³ of the sintering furnace volume and at a sintering temperature of 1450°C for 20 hours. The heating rate was 1°C/min and introduction of oxygen was terminated upon cooling after sintering to 1000°C at a cooling rate of 10°C/min.

The obtained sintered oxide was subjected to compositional analysis by ICP optical emission spectrometry and found to have almost the same composition as the charged composition at the time of weighing of the starting material powders. The sintered oxide was measured for the density which was found to be 5.49 g/cm³.

The sintered oxide was then subjected to the texture analysis by EPMA observation and the compositional analysis of crystal grains. The result of point analysis of the elemental distribution showed that, as shown in Tables 1 and 2, there were crystal grains (A) having a tin content that was less than the average tin content of the sintered oxide and crystal grains (B) having a tin content that was at or above the average tin content of the sintered oxide. The crystal grains (A) had an average composition of In: 99.7 at% and Sn: 0.3 at% and the crystal grains (B) had an average composition of In: 95.6 at% and Sn: 4.4 at%. Thus the difference in the average tin content between the crystal grains (A) and the crystal grains (B) was 0.041 in terms of the atomic ratio represented by Sn/ (In+Sn) . All crystal grains generally had a particle diameter of more than 1 µm.

The sintered oxide was subsequently subjected to phase identification by X-ray diffractometry and TEM observation. The obtained sintered oxide included only an In₂O₃ phase of bixbyite-type structure and the presence of an In₄Sn₃O₁₂ indium stannate compound phase was not confirmed.

From the above analysis results, it was concluded that the sintered oxide of the present Example mainly included the crystal grains (A) having a tin content that was less than the average tin content of the sintered oxide and the crystal grains (B) having a tin content that was at or above the average tin content of the sintered oxide and had a density of 3.4 to 5.5 g/cm³, wherein the crystal grains (A) and (B) contained tin in the form of solid solution and corresponded to crystal grains including an In₂O₃ phase of bixbyite-type structure.

The sintered oxide was processed to obtain tablets which were subjected to continuous discharge using a plasma gun by ion plating until the tablets were unusable. The ion plating device used was, as Example 1, a reactive plasma deposition apparatus for high density plasma assist deposition (HDPE) and discharge was carried out as Example 1. In order to examine film formation stability of tablets, specifically 10 tablets were observed until they were unusable for generation of problems such as cracks and breakage or splashing, which did not result in generation of the problematic phenomena.

Film formation was carried out using fresh tablets. A transparent conductive film having a thickness of 200 nm was formed with a 7059 substrate from Corning at a substrate temperature of 300°C. It was found that the resulting transparent conductive film had the composition almost the same as that of the tablets.

The film was measured for the specific resistance which was found to be 1.9 × 10⁻⁴ Ωcm. The film was measured for the transmittance and it was found that the average transmittance of visible light and the transmittance at a wavelength of 1200 nm were both above 85%. The result of analysis of crystallinity of the film by X-ray diffractometry showed that the film was a crystalline film only including an indium oxide phase and that tin in the form of solid solution was mixed with the indium oxide phase.

### (Example 16)

A sintered oxide and then tablets for ion plating were prepared in the same manner as Example 1 except that starting material powders were indium oxide powder having an average particle diameter of 1.5 µm or less and tin oxide powder having an average particle diameter of 3 µm and that the mixing time in a wet ball mill in the steps of obtaining primary mixed powder and secondary mixed powder was 8 hours.

The obtained sintered oxide was subjected to compositional analysis by ICP optical emission spectrometry and was found to have almost the same composition as the charged composition at the time of weighing of the starting material powders. The sintered oxide was measured for the density which was found to be 4.33 g/cm³.

The sintered oxide was then subjected to the texture analysis by EPMA observation and the compositional analysis of crystal grains. The result of point analysis of the elemental distribution showed that there were crystal grains (A) having a tin content that was less than the average tin content of the sintered oxide and crystal grains (B) having a tin content that was at or above the average tin content of the sintered oxide. The crystal grains (A) had an average composition of In: 97.1 at% and Sn: 2.9 at% and the crystal grains (B) had an average composition of In: 70.8 at% and Sn: 29.3 at%. Thus the difference in the average tin content between the crystal grains (A) and the crystal grains (B) was 0.264 in terms of the atomic ratio represented by Sn/ (In+Sn). All crystal grains generally had a particle diameter of more than 1 µm.

The sintered oxide was subsequently subjected to phase identification by X-ray diffractometry and TEM observation. As a result, it was found that the obtained sintered oxide included crystal grains including an In₂O₃ phase of bixbyite-type structure, an In₄Sn₃O₁₂ indium stannate compound phase and a small amount of tin oxide phase.

From the above analysis results, it was concluded, as shown in Tables 1 and 2, that the sintered oxide of the present Example mainly included the crystal grains (A) having a tin content that was less than the average tin content of the sintered oxide and the crystal grains (B) having a tin content that was at or above the average tin content of the sintered oxide and had a density of 3.4 to 5.5 g/cm³, wherein the crystal grains (A) and (B) contained tin in the form of solid solution and corresponded to any of crystal grains including an In₂O₃ phase of bixbyite-type structure, crystal grains (C) including an indium stannate compound phase and crystal grains (D) including a tin oxide phase which was contained at a small amount.

The sintered oxide was processed to obtain tablets which were subjected to continuous discharge using a plasma gun by ion plating until the tablets were unusable. The ion plating device used was, as Example 1, a reactive plasma deposition apparatus for high density plasma assist deposition (HDPE) and discharge was carried out as Example 1. In order to examine film formation stability of tablets, specifically 10 tablets were observed until they were unusable for generation of problems such as cracks and breakage or splashing, which did not result in generation of the problematic phenomena.

Film formation was carried out using fresh tablets. A transparent conductive film having a thickness of 200 nm was formed with a 7059 substrate from Corning at a substrate temperature of 300°C. The problems of cracks and breakage or splashing were not generated. However it was found that the film formation speed was decreased to 95% of the speed obtained in Example 1. It was found that the resulting transparent conductive film had the composition almost the same as that of the tablets.

The film was measured for the specific resistance which was found to be 2.2 × 10⁻⁴ Ωcm which was slightly higher than that of Example 1. The film was measured for the transmittance and it was found that the average transmittance of visible light was above 85% while the transmittance at a wavelength of 1200 nm was below 80%. The result of analysis of crystallinity of the film by X-ray diffractometry showed that the film was a crystalline film only including an indium oxide phase and that tin in the form of solid solution was mixed with the indium oxide phase.

### (Comparative Example 1)

A sintered oxide and then tablets for ion plating were prepared in the same manner as Example 1 except that starting material powders were weighed so as to obtain a tin content of 0.0005 in terms of the atomic ratio represented by Sn/(In+Sn) and the proportion of indium oxide powder mixed with the total amount of the tin oxide powder was 5% by weight of the total indium oxide powder.

The obtained sintered oxide was subjected to compositional analysis by ICP optical emission spectrometry and was found to have almost the same composition as the charged composition at the time of weighing of the starting material powders. The sintered oxide was measured for the density which was found to be 4.52 g/cm³.

The sintered oxide was then subjected to the texture analysis by EPMA observation and the compositional analysis of crystal grains. The result of point analysis of the elemental distribution showed that there were crystal grains having an amount of tin in the form of solid solution that was less than the average tin content of the sintered oxide and crystal grains having an amount of tin in the form of solid solution that was at or above the average tin content of the sintered oxide. The crystal grains (A) had an average composition of In: 100 at% because Sn was below the detection limit and the crystal grains (B) had an average composition of In: 98.4 at% and Sn: 1.6 at%. Thus the difference in the average tin content between the crystal grains (A) and the crystal grains (B) was 0.016 in terms of the atomic ratio represented by Sn/(In+Sn). All crystal grains generally had a particle diameter of more than 1 µm.

The sintered oxide was subsequently subjected to phase identification by X-ray diffractometry and TEM observation. The obtained sintered oxide included only an In₂O₃ phase of bixbyite-type structure and the presence of an In₄Sn₃O₁₂ indium stannate compound phase was not confirmed.

From the above analysis results, it was concluded, as shown in Tables 1 and 2, that the sintered oxide of the present Comparative Example mainly included the crystal grains (A) having a tin content that was less than the average tin content of the sintered oxide and the crystal grains (B) having a tin content that was at or above the average tin content of the sintered oxide and had a density of 3.4 to 5.5 g/cm³, wherein the crystal grains (A) and (B) contained tin in the form of solid solution and corresponded to crystal grains including an In₂O₃ phase of bixbyite-type structure.

The sintered oxide was processed to obtain tablets which were subjected to continuous discharge using a plasma gun by ion plating until the tablets were unusable. The ion plating device used was, as Example 1, a reactive plasma deposition apparatus for high density plasma assist deposition (HDPE) and discharge was carried out as Example 1. In order to examine film formation stability of tablets, specifically 10 tablets were observed until they were unusable for generation of problems such as cracks and breakage or splashing, which did not result in generation of the problematic phenomena.

Film formation was carried out using fresh tablets. A transparent conductive film having a thickness of 200 nm was formed with a 7059 substrate from Corning at a substrate temperature of 300°C. It was found that the resulting transparent conductive film had the composition almost the same as that of the tablets.

The film was measured for the specific resistance and found to have 6.1 × 10⁻⁴ Ωcm which was above 5.0 × 10⁻⁴ Ωcm. The film was measured for the transmittance and it was found that the average transmittance of visible light and the transmittance at a wavelength of 1200 nm were both above 80%. The result of analysis of crystallinity of the film by X-ray diffractometry showed that the film was a crystalline film only including an indium oxide phase and that tin in the form of solid solution was mixed with the indium oxide phase.

### (Comparative Example 2)

A sintered oxide and then tablets for ion plating were prepared in the same manner as Example 1 except that starting material powders were weighed so as to obtain a tin content of 0.19 in terms of the atomic ratio represented by Sn/(In+Sn) and the proportion of indium oxide powder mixed with the total amount of the tin oxide powder was 50% by weight of the total indium oxide powder.

The obtained sintered oxide was subjected to compositional analysis by ICP optical emission spectrometry and was found to have almost the same composition as the charged composition at the time of weighing of the starting material powders. The sintered oxide was measured for the density which was found to be 4.85 g/cm³.

The sintered oxide was then subjected to the texture analysis by EPMA observation and the compositional analysis of crystal grains. The result of point analysis of the elemental distribution showed that there were crystal grains (A) having a tin content that was less than the average tin content of the sintered oxide and crystal grains (B) having a tin content that was at or above the average tin content of the sintered oxide. The crystal grains (A) had an average composition of In: 93.9 at% and Sn: 6.1 at% and the crystal grains (B) had an average composition of In: 59.9 at% and Sn : 40.1 at%. Thus the difference in the average tin content between the crystal grains (A) and the crystal grains (B) was 0.34 in terms of the atomic ratio represented by Sn/ (In+Sn) . All crystal grains generally had a particle diameter of more than 1 µm.

The sintered oxide was subsequently subjected to phase identification by X-ray diffractometry and TEM observation. As a result, it was found that the obtained sintered oxide included an In₂O₃ phase of bixbyite-type structure and an In₄Sn₃O₁₂ indium stannate compound phase.

From the above analysis results, it was concluded, as shown in Tables 1 and 2, that the sintered oxide of the present Comparative Example mainly included the crystal grains (A) having a tin content that was less than the average tin content of the sintered oxide and the crystal grains (B) having a tin content that was at or above the average tin content of the sintered oxide and had a density of 3.4 to 5.5 g/cm³, wherein the crystal grains (A) and (B) contained tin in the form of solid solution and corresponded to either crystal grains including an In₂O₃ phase of bixbyite-type structure or crystal grains (C) including an indium stannate compound phase.

The sintered oxide was processed to obtain tablets which were subjected to continuous discharge using a plasma gun by ion plating until the tablets were unusable. The ion plating device used was, as Example 1, a reactive plasma deposition apparatus for high density plasma assist deposition (HDPE) and discharge was carried out as Example 1. In order to examine film formation stability of tablets, specifically 10 tablets were observed until they were unusable for generation of problems such as cracks and breakage or splashing, which did not result in generation of the problematic phenomena.

Film formation was carried out using fresh tablets. A transparent conductive film having a thickness of 200 nm was formed with a 7059 substrate from Corning at a substrate temperature of 300°C. It was found that the resulting transparent conductive film had the composition almost the same as that of the tablets.

The film was measured for the specific resistance and found to have 9.7 × 10⁻⁴ Ωcm which was higher than 5.0 × 10⁻⁴ Ωcm. The film was measured for the transmittance and it was found that the average transmittance of visible light was above 80% while the transmittance at a wavelength of 1200 nm was below 80%. The result of analysis of crystallinity of the film by X-ray diffractometry showed that the film was a crystalline film only including an indium oxide phase and that tin in the form of solid solution was mixed with the indium oxide phase.

### (Comparative Example 3)

A sintered oxide and then tablets for ion plating were prepared in the same composition and manner as Example 4 except that the total amount of the weighed indium oxide powder and the total amount of the tin oxide powder were placed in a resin pot together with water, a dispersing agent and the like and mixed in a wet ball mill followed by removal, filtration and drying of slurry to obtain primary mixed powder and that the primary mixed powder was directly granulated, molded and subjected to sintering.

The obtained sintered oxide was subjected to compositional analysis by ICP optical emission spectrometry and found to have almost the same composition as the charged composition at the time of weighing of the starting material powders. The sintered oxide was measured for the density which was found to be 5.01 g/cm³.

The sintered oxide was then subjected to the texture analysis by EPMA observation and the compositional analysis of crystal grains. The result of point analysis of the elemental distribution showed that the crystal grains including an In₂O₃ phase had an amount of tin in the form of solid solution that was equivalent to the average tin content of the sintered oxide. Thus there was no difference in the composition between crystal grains (all crystal grains (B)) and the average composition thereof was In: 96.7 at% and Sn: 3.3 at%. All crystal grains generally had a particle diameter of more than 1 µm.

The sintered oxide was subsequently subjected to phase identification by X-ray diffractometry and TEM observation. The obtained sintered oxide included only an In₂O₃ phase of bixbyite-type structure and the presence of an In₄Sn₃O₁₂ indium stannate compound phase was not confirmed.

From the above analysis results, it was concluded, as shown in Tables 1 and 2, that the sintered oxide of the present Comparative Example mainly included the crystal grains (A) having a tin content that was less than the average tin content of the sintered oxide and the crystal grains (B) having a tin content that was at or above the average tin content of the sintered oxide and had a density of 3.4 to 5.5 g/cm³, wherein the crystal grains (A) and (B) contained tin in the form of solid solution and corresponded to crystal grains including an In₂O₃ phase of bixbyite-type structure.

The sintered oxide was processed to obtain tablets which were subjected to continuous discharge using a plasma gun by ion plating until the tablets were unusable. The ion plating device used was, as Example 1, a reactive plasma deposition apparatus for high density plasma assist deposition (HDPE) and discharge was carried out as Example 1. In order to examine film formation stability of tablets, specifically 10 tablets were observed until they were unusable for generation of problems such as cracks and breakage or splashing. Three tablets out of 10 had breakage before the film formation period at which the tablets were expected to be unusable under normal usage conditions. Examination as to how the breakage was generated revealed that as the film formation period progressed, many cracks were generated in the tablets which were ultimately broken, resulting in failure of continuation of discharge.

Film formation was carried out using tablets without breakage. A transparent conductive film having a thickness of 200 nm was formed with a 7059 substrate from Corning at a substrate temperature of 300°C. It was found that the resulting transparent conductive film had the composition almost the same as that of the tablets.

The film was measured for the specific resistance which was found to be 2.0 × 10⁻⁴ Ωcm. The film was measured for the transmittance and it was found that the average transmittance of visible light and the transmittance at a wavelength of 1200 nm were both above 80%. The result of analysis of crystallinity of the film by X-ray diffractometry showed that the film was a crystalline film only including an indium oxide phase and that tin in the form of solid solution was mixed with the indium oxide phase.

### (Comparative Example 4)

Starting material powders were indium oxide powder and tin oxide powder both of which had an average particle diameter of 1.5 µm or less. Both powders were weighed so as to obtain a tin content of 0.003 in terms of the atomic ratio of Sn/(In+Sn). Among these, 50% by weight of indium oxide powder and the total amount of tin oxide powder were placed in a resin pot together with water, a dispersing agent and the like and mixed in a wet ball mill. Hard ZrO₂ balls were used for mixing of 18 hours. After mixing, slurry was removed, filtered and dried to obtain primary mixed powder. The primary mixed powder was then calcinated in a sintering furnace with a heating rate of 1°C/min under the conditions of 900°C and 10 hours. The residual indium oxide powder was not calcinated. The calcinated powder and the non-calcinated powder were then again mixed in a wet ball mill. After mixing, slurry was filtered and dried to obtain secondary mixed powder. The secondary mixed powder was then granulated. The granulated powder was then charged in a mold and molded on a uniaxial press while applying pressure of 4.9 MPa so as to have the shape of tablets. The tablet was molded so as to have the dimensions after sintering of 30 mm in diameter and 40 mm in height.

The molded articles were then sintered as follows. The molded articles were sintered in an atmosphere wherein oxygen was introduced to air in the sintering furnace at a rate of 5 liter/min per 0.1 m³ of the sintering furnace volume and at a sintering temperature of 900°C for 20 hours. The heating rate was 1°C/min and introduction of oxygen was terminated upon cooling after sintering.

The obtained sintered oxide was subjected to compositional analysis by ICP optical emission spectrometry and found to have almost the same composition as the charged composition at the time of weighing of the starting material powders. The sintered oxide was measured for the density which was found to be 3.27 g/cm³.

The sintered oxide was then subjected to the texture analysis by EPMA observation and the compositional analysis of crystal grains. The result of point analysis of the elemental distribution showed that there were crystal grains (A) having a tin content that was less than the average tin content of the sintered oxide and crystal grains (B) having a tin content that was at or above the average tin content of the sintered oxide. The crystal grains (A) had an average composition of In: 99.9 at% and Sn: 0.1 at% and the crystal grains (B) had an average composition of In: 99.0 at% and Sn: 1.0 at%. Thus the difference in the average tin content between the crystal grains (A) and the crystal grains (B) was 0.01 in terms of the atomic ratio represented by Sn/(In+Sn). All crystal grains generally had a particle diameter of more than 1 µm.

The sintered oxide was subsequently subjected to phase identification by X-ray diffractometry and TEM observation. The obtained sintered oxide included only an In₂O₃ phase of bixbyite-type structure and the presence of an In₄Sn₃O₁₂ indium stannate compound phase was not confirmed.

From the above analysis results, it was concluded, as shown in Tables 1 and 2, that the sintered oxide of the present Comparative Example mainly included the crystal grains (A) having a tin content that was less than the average tin content of the sintered oxide and the crystal grains (B) having a tin content that was at or above the average tin content of the sintered oxide and had a density of 3.4 to 5.5 g/cm³, wherein the crystal grains (A) and (B) contained tin in the form of solid solution and corresponded to crystal grains including an In₂O₃ phase of bixbyite-type structure.

The sintered oxide was processed to obtain tablets which were subjected to continuous discharge using a plasma gun by ion plating until the tablets were unusable. The ion plating device used was, as Example 1, a reactive plasma deposition apparatus for high density plasma assist deposition (HDPE) and discharge was carried out as Example 1. In order to examine film formation stability of tablets, specifically 10 tablets were observed until they were unusable for generation of problems such as cracks and breakage or splashing. Four tablets out of 10 had breakage before the film formation period at which the tablets were expected to be unusable under normal usage conditions. Examination as to how the breakage was generated revealed that as the film formation period progressed, many cracks were generated in the tablets which were ultimately broken, resulting in failure of continuation of discharge.

Film formation was carried out using tablets without breakage. A transparent conductive film having a thickness of 200 nm was formed with a 7059 substrate from Corning at a substrate temperature of 300°C. It was found that the resulting transparent conductive film had the composition almost the same as that of the tablets.

The film was measured for the specific resistance which was found to be 3.2 × 10⁻⁴ Ωcm. The film was measured for the transmittance and it was found that the average transmittance of visible light and the transmittance at a wavelength of 1200 nm were both above 80%. The result of analysis of crystallinity of the film by X-ray diffractometry showed that the film was a crystalline film only including an indium oxide phase and that tin in the form of solid solution was mixed with the indium oxide phase.

### (Comparative Example 5)

Starting material powders were indium oxide powder and tin oxide powder both of which had an average particle diameter of 1.5 µm or less. Both powders were weighed so as to obtain a tin content of 0.008 in terms of the atomic ratio of Sn/(In+Sn). Among these, 15% by weight of indium oxide powder and the total amount of tin oxide powder were placed in a resin pot together with water, a dispersing agent and the like and mixed in a wet ball mill. Hard ZrO₂ balls were used for mixing of 18 hours. After mixing, slurry was removed, filtered and dried to obtain primary mixed powder. The primary mixed powder was then calcinated in a sintering furnace with a heating rate of 1°C/min under the conditions of 900°C and 10 hours. The residual indium oxide powder was not calcinated. The calcinated powder and the non-calcinated powder were then again mixed in a wet ball mill. After mixing, slurry was filtered and dried to obtain secondary mixed powder. The secondary mixed powder was then granulated. The granulated powder was then charged in a mold and molded on a uniaxial press while applying pressure of 4. 9 MPa so as to have the shape of tablets. The tablet was molded so as to have the dimensions after sintering of 30 mm in diameter and 40 mm in height.

The molded articles were then sintered as follows. The molded articles were sintered in an atmosphere wherein oxygen was introduced to air in the sintering furnace at a rate of 5 liter/min per 0.1 m³ of the sintering furnace volume and at a sintering temperature of 1450°C for 20 hours. The heating rate was 1°C/min, and introduction of oxygen was terminated upon cooling after sintering.

The obtained sintered oxide was subjected to compositional analysis by ICP optical emission spectrometry and found to have almost the same composition as the charged composition at the time of weighing of the starting material powders. The sintered oxide was measured for the density which was found to be 5.96 g/cm³.

The sintered oxide was then subjected to the texture analysis by EPMA observation and the compositional analysis of crystal grains. The result of point analysis of the elemental distribution showed that there were crystal grains (A) having a tin content that was less than the average tin content of the sintered oxide and crystal grains (B) having a tin content that was at or above the average tin content of the sintered oxide. The crystal grains (A) had an average composition of In: 99.7 at% and Sn: 0.3 at% and the crystal grains (B) had an average composition of In: 94.3 at% and Sn: 5.7 at%. Thus the difference in the average tin content between the crystal grains (A) and the crystal grains (B) was 0.054 in terms of the atomic ratio represented by Sn/(In+Sn). All crystal grains generally had a particle diameter of more than 1 µm.

The sintered oxide was subsequently subjected to phase identification by X-ray diffractometry and TEM observation. The obtained sintered oxide included only an In₂O₃ phase of bixbyite-type structure and the presence of an In₄Sn₃O₁₂ indium stannate compound phase was not confirmed.

From the above analysis results, it was concluded, as shown in Tables 1 and 2, that the sintered oxide of the present Comparative Example mainly included the crystal grains (A) having a tin content that was less than the average tin content of the sintered oxide and the crystal grains (B) having a tin content that was at or above the average tin content of the sintered oxide and had a density of 3.4 to 5.5 g/cm³, wherein the crystal grains (A) and (B) contained tin in the form of solid solution and corresponded to crystal grains including an In₂O₃ phase of bixbyite-type structure.

The sintered oxide was processed to obtain tablets which were subjected to continuous discharge using a plasma gun by ion plating until the tablets were unusable. The ion plating device used was, as Example 1, a reactive plasma deposition apparatus for high density plasma assist deposition (HDPE) and discharge was carried out as Example 1. In order to examine film formation stability of tablets, specifically 10 tablets were observed until they were unusable for generation of problems such as cracks and breakage or splashing. Five tablets out of 10 had breakage at a relatively early stage before the film formation period at which the tablets were expected to be unusable under normal usage conditions. Examination as to how the breakage was generated revealed that as the film formation period progressed, many cracks were generated in the tablets which were ultimately broken, resulting in failure of continuation of discharge.

Film formation was carried out using tablets without breakage. A transparent conductive film having a thickness of 200 nm was formed with a 7059 substrate from Corning at a substrate temperature of 300°C. It was found that the resulting transparent conductive film had the composition almost the same as that of the tablets.

The film was measured for the specific resistance which was found to be 2.9 × 10⁻⁴ Ωcm. The film was measured for the transmittance and it was found that the average transmittance of visible light and the transmittance at a wavelength of 1200 nm were both above 80%. The result of analysis of crystallinity of the film by X-ray diffractometry showed that the film was a crystalline film only including an indium oxide phase and that tin in the form of solid solution was mixed with the indium oxide phase.

**Table 1**

| | Sn/(In+Sn) (atomic ratio) | M element | Sn/(In+Sn+M) (atomic ratio) | M/(In+Sn+M) (atomic ratio) |
|---|---|---|---|---|
| Ex. 1 | 0.09 | - | - | - |
| Ex. 2 | 0.008 | - | - | - |
| Ex. 3 | 0.019 | - | - | - |
| Ex. 4 | 0.031 | - | - | - |
| Ex. 5 | 0.046 | - | - | - |
| Ex. 6 | 0.07 | - | - | - |
| Ex. 7 | 0.14 | - | - | - |
| Ex. 8 | 0.037 | - | - | - |
| Ex. 9 | - | Ti | 0.008 | 0.008 |
| Ex. 10 | - | Zr | 0.008 | 0.008 |
| Ex. 11 | - | Hf | 0.008 | 0.008 |
| Ex. 12 | - | W | 0.008 | 0.008 |
| Ex. 13 | - | Ti, Mo | 0.006 | 0.012 |
| Ex. 14 | 0.008 | - | - | - |
| Ex. 15 | 0.008 | - | - | - |
| Ex. 16 | 0.09 | - | - | - |
| Comp. Ex. 1 | 0.0005 | - | - | - |
| Comp. Ex. 2 | 0.19 | - | - | - |
| Comp. Ex. 3 | 0.031 | - | - | - |
| Comp. Ex. 4 | 0.003 | - | - | - |
| Comp. Ex. 5 | 0.008 | - | - | - |

**Table 2**

| | Crystal grains (A) of less than average tin content | Crystal grains (B) of at or above average tin content | Crystal grains (C) including indium stannate compound phase | Crystal grains (D) including tin oxide phase | Difference in tin content (atomic ratio) | Density of sintered substance (g/cm³) | Cracks, breakage, splashing | Specific resistance of film (× 10⁻⁴ Ωcm) |
|---|---|---|---|---|---|---|---|---|
| Ex. 1 | O | O | O | - | 0.235 | 4.94 | No | 1.7 |
| Ex. 2 | O | O | - | - | 0.015 | 4.88 | No | 2.8 |
| Ex. 3 | O | O | - | - | 0.04 | 4.95 | No | 2.6 |
| Ex. 4 | O | O | - | - | 0.064 | 4.95 | No | 2.0 |
| Ex. 5 | O | O | O | - | 0.206 | 5.02 | No | 1.4 |
| Ex. 6 | O | O | O | - | 0.139 | 4.94 | No | 1.9 |
| Ex. 7 | O | O | O | - | 0.261 | 4.85 | No | 3.5 |
| Ex. 8 | O | O | - | - | 0.052 | 4.87 | No | 1.9 |
| Ex. 9 | O | O | - | - | 0.027 | 5.02 | No | 2.1 |
| Ex. 10 | O | O | - | - | 0.026 | 4.81 | No | 2.5 |
| Ex. 11 | O | O | - | - | 0.027 | 4.95 | No | 2.4 |
| Ex. 12 | O | O | - | - | 0.028 | 4.67 | No | 2.1 |
| Ex. 13 | O | O | - | - | 0.021 | 4.74 | No | 2.4 |
| Ex. 14 | O | O | - | - | 0.016 | 3.44 | No | 2.2 |
| Ex. 15 | O | O | - | - | 0.041 | 5.49 | No | 1.9 |
| Ex. 16 | O | O | O | O | 0.264 | 4.33 | No | 2.2 |
| Comp. Ex. 1 | O | O | - | - | 0.016 | 4.52 | No | 6.1 |
| Comp. Ex. 2 | O | O | O | - | 0.34 | 4.89 | No | 9.7 |
| Comp. Ex. 3 | - | O | - | - | 0 | 5.01 | Yes | 2.0 |
| Comp. Ex. 4 | O | O | - | - | 0.01 | 3.27 | Yes | 3.2 |
| Comp. Ex. 5 | O | O | O | - | 0.054 | 5.96 | Yes | 2.9 |

### Evaluation

The sintered oxides of Examples 1 to 8 respectively were, according to the present invention, prepared from starting material powders of indium oxide powder and tin oxide powder having an average particle diameter of 1.5 µm or less, contain indium oxide as a main component and tin as an additive element and have a tin content of 0.001 to 0.15 in terms of the atomic ratio of Sn/(In+Sn).

Among these, Examples 1 to 7 were prepared with secondary mixed powder obtained by mixing calcinated powder which was obtained by calcinating primary mixed powder of 50% by weight of indium oxide powder and the total amount of tin oxide powder among indium oxide powder and tin oxide powder weighed so as to have a specific composition and non-calcinated powder which corresponded to the residual indium oxide powder. Because of this, as apparent from the results shown in Tables 1 and 2, all of these sintered oxides respectively include crystal grains (A) having a tin content that is less than the average tin content of the sintered oxide and crystal grains (B) having a tin content that is at or above the average tin content of the sintered oxide. Among Examples 1 to 7, Examples 2 to 4 respectively include crystal grains including only an indium oxide phase of bixbyite-type structure with which tin is mixed in the form of solid solution and do not contain crystal grains (C) including an In₄Sn₃O₁₂ phase which is the indium stannate compound phase, while Examples 1 and 5 to 7 respectively include both phases. The sintered oxides of Examples 1 to 7 respectively have a density in the range of 4.8 to 5.0 g/cm³ and a theoretical density ratio of around 70% which is not necessarily high. However the sintered oxides were confirmed that they do not cause cracks and breakage or splashing during film formation by ion plating. Thus having different phases of crystal grains in the sintered oxides, the sintered oxides of Examples 1 to 7 have enough strength allowing the sintered oxides being resistant to thermal shock and thermal expansion during film formation by ion plating in spite of low density of the sintered oxides by mainly including the crystal grains (A) having a tin content that is less than the average tin content of the sintered oxide and the crystal grains (B) having a tin content that is at or above the average tin content of the sintered oxide.

In Example 8, the amount of indium oxide powder used for calcinated powder was 75% by weight. Even in this case, it was confirmed that the sintered oxide had, because the sintered oxide contained similar crystal grains as Examples 2 to 4, sufficient strength without causing cracks and breakage or splashing during film formation by ion plating in spite of the density thereof of 4.87 g/cm³.

In Examples 1 to 8, transparent conductive films having the composition corresponding to a tin content of 0.001 to 0.15 in terms of the atomic ratio of Sn/ (In+Sn) showed a specific resistance as low as 5.0 × 10⁻⁴ Ωcm or less. Further, the transparent conductive films of Examples 2 to 4 having the composition corresponding to a tin content in the range of 0.003 to 0.04 in terms of the atomic ratio of Sn/(In+Sn) showed low specific resistance of 3.0 × 10⁻⁴ Ωcm or less as well as a transmittance at a wavelength of 1200 nm of 80% or above, and thus it was revealed that the transparent conductive films were sufficiently useful as transparent electrodes for solar cells.

In contrast, Comparative Examples 1 and 2 had a tin content of 0.0005 or 0.19 in terms of the atomic ratio of Sn/ (In+Sn) that were outside of the range of 0.001 to 0.15, and thus, although they allowed to obtain sintered oxides having similar structures and textures as Examples 1 to 8, had a specific resistance above 5.0× 10⁻⁴ Ωcm, making it difficult to apply the sintered oxides to surface electrodes of solar cells and the like.

In Comparative Example 3, unlike Examples 1 to 8, mixed powder of the total amount of the weighed indium oxide and the total amount of the tin oxide was directly used for preparation of the sintered oxide without calcination and the like. Therefore the sintered oxide only includes crystal grains including an indium oxide phase of bixbyite-type structure having a tin content that is equivalent to the average tin content of the sintered oxide. Namely the sintered oxide is not mainly formed with the crystal grains (A) having a tin content that is less than the average tin content of the sintered oxide and the crystal grains (B) having a tin content that is at or above the average tin content of the sintered oxide which are characteristic to the present invention. As a result, the sintered substance has, in spite of the density that is equivalent to Examples 1 to 8, insufficient strength, resulting in cracks and breakage or splashing during film formation by ion plating.

The sintered oxides of Examples 9 to 13 respectively include indium oxide as a main component, tin as an additive element and further one or more metal elements (M elements) selected from the group of metal elements consisting of titanium, zirconium, hafnium, molybdenum and tungsten as an additive element and have a total content of tin and the M element (s) of 0.001 to 0.15 in terms of the atomic ratio of (Sn+M)/(In+Sn+M). Such sintered oxides containing M element(s) in addition to tin allow both low density as around 70% in terms of the theoretical density ratio and high strength, resulting in suppression of cracks and breakage or splashing during film formation by ion plating by mainly including, as Examples 1 to 8, the crystal grains (A) having a tin content that is less than the average tin content of the sintered oxide and the crystal grains (B) having a tin content that is at or above the average tin content of the sintered oxide.

In Examples 14 and 15, the sintered oxides have a density that is around the lower and upper limits of the range according to the present invention, i.e. the range of 3.4 to 5.5 g/cm³. Even in these cases, it was found that the sintered oxides had sufficient strength without causing cracks and breakage or splashing during film formation by ion plating.

In contrast, Comparative Examples 4 and 5 which had a density outside of the range according to the present invention had insufficient strength due to the extremely low density, were vulnerable to thermal shock due to extremely high density to the contrary or had the difference in the average tin content between the crystal grains (B) and the crystal grains (A) of below 0.015 in terms of the atomic ratio of Sn/(In+Sn), and thus caused a high rate of generation of cracks and breakage or splashing during film formation by ion plating in tablets.

In Example 16, tin oxide powder having a relatively high average particle diameter of 3 µm was used as a starting material powder and the mixing time in a ball mill for preparation of primary mixed powder and secondary mixed powder was decreased compared to Examples 1 to 8. As a result, the obtained sintered oxide mainly included the crystal grains (A) having a tin content that was less than the average tin content of the sintered oxide and the crystal grains (B) having a tin content that was at or above the average tin content of the sintered oxide and had a density of 3.4 to 5.5 g/cm³, wherein the crystal grains (A) and (B) contained tin in the form of solid solution and corresponded to any of crystal grains including an In₂O₃ phase of bixbyite-type structure, crystal grains (C) including an indium stannate compound phase and crystal grains (D) including a tin oxide phase which was contained at a small amount. Among these, the crystal grains (D) including a tin oxide phase caused a decrease in the film formation speed in some extent during film formation by ion plating; however the crystal grains (D) including a tin oxide phase, which were suspected to cause cracks and breakage or splashing during film formation by ion plating, did not cause the phenomena because the amount thereof was extremely low and were confirmed that the grains do not cause substantial problems. However, it was found that the crystal grains (D) including a tin oxide phase may cause a decrease in the film formation speed.

In Examples 1 to 16, it was found that the difference in the average tin content between the crystal grains (B) and the crystal grains (A) is 0.015 or more in terms of the atomic ratio of Sn/(In+Sn). Namely it was found that controlling tablets as described above contributes to suppression of cracks and breakage or splashing during film formation by ion plating.

### INDUSTRIAL APPLICABILITY

The present invention is a sintered oxide containing indium and tin, mainly including crystal grains (A) having a tin content that is less than the average tin content of the sintered oxide and crystal grains (B) having a tin content that is at or above the average tin content of the sintered oxide, the difference in the average tin content between the crystal grains (B) and the crystal grains (A) being 0.015 or more in terms of the atomic ratio of Sn/ (In+Sn), and having a density of 3.4 to 5.5 g/cm³, and a tablet for ion plating obtained by processing the sintered oxide and can be used in formation of oxide transparent conductive films by ion plating without causing cracks and breakage or splashing. The transparent conductive films are extremely useful in industrial fields as surface electrodes of solar cells. The transparent conductive films can also be suitably used for optical communication devices such as waveguide optical control devices utilizing relatively low specific resistance and high transmittance in the infrared range and light modulation devices utilizing liquid crystal as well as functional elements such as liquid crystal panels, plasma displays, LED devices, organic EL, inorganic EL and electronic paper.

## Claims

1. A sintered oxide comprising indium oxide as a main component and tin as an additive element, and having a tin content of 0.001 to 0.15 in terms of an atomic ratio of Sn/ (In+Sn), wherein:
the sintered oxide mainly comprises crystal grains (A) having a tin content that is less than an average tin content of the sintered oxide and crystal grains (B) having a tin content that is at or above the average tin content of the sintered oxide, a difference in the average tin content between the crystal grains (B) and the crystal grains (A) being 0.015 or more in terms of the atomic ratio of Sn/(In+Sn), and has a density of 3.4 to 5.5 g/cm³.

2. A sintered oxide comprising indium oxide as a main component and tin as an additive element, and further comprising one or more metal elements (M elements) selected from the group of metal elements consisting of titanium, zirconium, hafnium, molybdenum and tungsten as an additive element and having a total content of tin and the M element(s) of 0.001 to 0.15 in terms of an atomic ratio of (Sn+M)/(In+Sn+M), wherein:
the sintered oxide comprises crystal grains (A) having at least a tin content that is less than an average tin content of the sintered oxide and crystal grains (B) having at least a tin content that is at or above the average tin content of the sintered oxide, a difference in the average tin content between the crystal grains (B) and the crystal grains (A) being 0.015 or more in terms of an atomic ratio of Sn/(In+Sn+M), and has a density of 3.4 to 5.5 g/cm³.

3. The sintered oxide according to claim 1 or 2, having a tin content of 0.003 to 0.05 in terms of the atomic ratio of Sn/(In+Sn).

4. The sintered oxide according to claim 2, having the total content of tin and the M element (s) of 0.003 to 0.05 in terms of the atomic ratio of (Sn+M)/(In+Sn+M).

5. The sintered oxide according to claim 1 or 2, wherein the crystal grains (A) have an average tin content that is 0.04 or less in terms of an atomic ratio of tin relative to all metal elements, and the crystal grains (B) have an average tin content that is 0.15 or more in terms of the atomic ratio of tin relative to all metal elements.

6. The sintered oxide according to claim 1 or 2, wherein the crystal grains (A) and the crystal grains (B) contain tin in the form of solid solution and include an In₂O₃ phase of bixbyite-type structure.

7. The sintered oxide according to claim 1 or 2, further comprising, in addition to the crystal grains (A) and the crystal grains (B), crystal grains (C) including an indium stannate compound phase.

8. The sintered oxide according to claim 1 or 2, devoid of crystal grains (D) including a tin oxide phase.

9. A tablet obtained by processing the sintered oxide according to any of claims 1 to 8.
